(19) Europäisches Patentamt
European Patent Office
Office européen des brevets

(11) EP 3 576 974 B1

(12) EUROPÄISCHE PATENTSCHRIFT

(45) Veröffentlichungstag und Bekanntmachung des Hinweises auf die Patenterteilung:
17.03.2021 Patentblatt 2021/11

(51) Int Cl.:
B60K 37/06 (2006.01)　　G06F 3/01 (2006.01)

(21) Anmeldenummer: 18703539.9

(22) Anmeldetag: 30.01.2018

(86) Internationale Anmeldenummer:
PCT/EP2018/052273

(87) Internationale Veröffentlichungsnummer:
WO 2018/141745 (09.08.2018 Gazette 2018/32)

(54) **BEDIENEINHEIT FÜR EIN GERÄT, INSBESONDERE FÜR EINE FAHRZEUGKOMPONENTE**

OPERATING UNIT FOR A DEVICE, IN PARTICULAR FOR A VEHICLE COMPONENT

UNITÉ DE COMMANDE POUR UN APPAREIL, EN PARTICULIER POUR UN COMPOSANT DE VÉHICULE

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 01.02.2017 DE 102017201624
16.05.2017 DE 102017208238

(43) Veröffentlichungstag der Anmeldung:
11.12.2019 Patentblatt 2019/50

(73) Patentinhaber: Behr-Hella Thermocontrol GmbH
70469 Stuttgart (DE)

(72) Erfinder:
• KIRSCH, Stefan
59494 Soest (DE)
• PANKRATZ, Harri
59505 Bad Sassendorf (DE)
• NAGEL, Dirk
33102 Paderborn (DE)

(74) Vertreter: dompatent von Kreisler Selting Werner - Partnerschaft von Patent- und Rechtsanwälten mbB
Deichmannhaus am Dom
Bahnhofsvorplatz 1
50667 Köln (DE)

(56) Entgegenhaltungen:
EP-A1- 2 479 654　　US-A1- 2011 276 878
US-A1- 2013 127 767

**Beschreibung**

Die Erfindung betrifft eine Bedieneinheit für ein Gerät, z.B. für eine Fahrzeugkomponente. In ihrer allgemeinsten Form betrifft die Erfindung ein Mensch-Maschine-Interface (MMI bzw. HMI) mit aktivem haptischem Feedback unter Kompensation von nach außen wirkenden Kräften, so dass infolge des aktiven, haptischen Feedback auftretende Schwingungen der Bedieneinheit sich nicht nachteilig (beispielsweise hinsichtlich Akustik und Mechanik) auf die Umgebung der Bedieneinheit auswirken.

Display-Baugruppen in Kraftfahrzeugen werden oftmals mit einem aktiven haptischen Feedback ausgerüstet. Dabei soll das Auslösen des Feedbacks auf einem mit nicht zu vernachlässigender Masse behafteten Bedienfeld keine unzulässige dynamische Kraftübertragung auf das Fahrzeug erzeugen, da dies je nach Einbausituation zu parasitären Geräuschen bzw. Vibrationen im Fahrzeug führen kann.

Desweiteren soll das haptische Feedback weitgehend unabhängig von der Elastizität der Anbindung der Bedieneinheit an deren Umgebung (z.B. Instrumententafel, Mittelkonsole) sein.

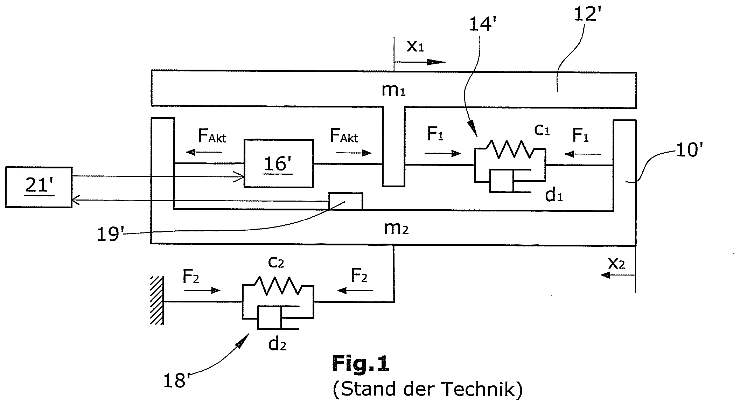

Ein mit einem aktiven haptischen Feedback ausgestattetes Gerät besteht im Wesentlichen aus einem Bedienelement mit Bedienfeld, Touchpad oder Touchscreen, das über ein Federsystem am Gerätegehäuse elastisch befestigt ist, einem Aktuator zur Auslenkung des Bedienfelds und einem Gehäuse, das z.B. in einem Fahrzeug fest verbaut ist. In Fig. 1 sind die wirkenden Kräfte in einem solchen Geräteaufbau dargestellt.

Zur Erzeugung des haptischen Feedbacks wird das Display mit einem bestimmten Wegverlauf $x_1(t)$ aus seiner Ruhelage ausgelenkt. Die Displaybeschleunigung $a_1(t)$ kann hierbei Werte von mehr als $30 \ m/s^2$ annehmen, was bei einer bewegten Displaymasse $m_1$ von über 0,5 kg und einer in der Regel kleinen Gehäusemasse $m_2$ zu einer nicht zu vernachlässigenden dynamischen Kraft $F_2(t)$ auf die Gerätebefestigung im Fahrzeug führt.

Bei einer steifen Gerätehalterung bzw. -befestigung (steifes Federsystem $c_2$, $d_2$) kann diese zeitlich schnell veränderliche Kraft unzulässige Geräusche bzw. Vibrationen im Fahrzeug verursachen.

Bei einer weichen Befestigung (weiches Federsystem $c_2$, $d_2$) dagegen erweist sich das Einhalten von Einbautoleranzen des Geräts im Fahrzeug als schwierig. Fernerhin ist die Abstimmung des erforderlichen Aktuatorkraftverlaufs $F_{Akt}(t)$ durch das Vorhandensein eines weiteren Freiheitsgrades, nämlich der Gehäusebewegung $x_2(t)$ und somit auch zusätzlicher Eigenfrequenzen im System, unter Umständen nicht möglich.

Es ist bekannt, durch gegenläufig zum Bedienelement anregbare Ausgleichsmassen für eine Kompensation der auf das Gehäuse wirkenden Kräfte sorgen zu wollen, die auf Grund der mechanischen Anregung des Bedienelements auf das Gehäuse einwirken. Für die entsprechende Hardware (Aktuator und Ausgleichsmasse sowie Federsysteme) wird innerhalb des Gehäuses Bauraum benötigt.

Eine Bedieneinheit für ein Gerät, insbesondere für eine Fahrzeugkomponente, gemäß dem Oberbegriff des Anspruchs 1 bzw. 13 ist aus US-A-2011/276878 bekannt.

Aufgabe der Erfindung ist es, ein hinsichtlich der Entstehung von parasitären Geräuschen bzw. Vibrationen verbessertes Konzept für eine Bedieneinheit mit aktivem haptischen Feedback zu schaffen, wobei der Platzbedarf für den Aktuator und die Ausgleichsmasse sowie die Federn möglichst gering sein soll.

Zur Lösung dieser Aufgabe wird mit der Erfindung eine Bedieneinheit für ein Gerät, insbesondere für eine Fahrzeugkomponente und allgemein gesagt ein Mensch-Maschine-Interface (MMI bzw. HMI) vorgeschlagen, wobei die Bedieneinheit versehen ist mit

- einem Gehäuse, das ein Bedienelement mit einem Bedienfeld, wie z.B. ein Touchscreen oder ein Touchpad oder ein Display oder eine Abdeckscheibe eines Touchscreen oder eines Displays aufweist und zur Befestigung in/an einem Gerät, insbesondere an einer Fahrzeug-Instrumententafel oder Fahrzeug-Mittelkonsole vorgesehen ist,
- wobei das Bedienelement elastisch in dem Gehäuse gelagert ist,
- einem Sensor zur Erkennung einer Bedienung des Bedienelements,
- einem Aktuator zur bei Erkennung einer Bedienung des Bedienelements erfolgenden mechanischen Anregung des Bedienelements und
- einer Ausgleichsmasse, die beweglich in/an dem Gehäuse gelagert ist,
- wobei die Ausgleichsmasse bei Erkennung einer Bedienung des Bedienelements von dem oder von einem Aktuator mechanisch anregbar ist,
- wobei die Ausgleichsmasse zur im Wesentlichen Kompensation und/oder Verhinderung und/oder Dämpfung von Kräften bewegbar ist, die infolge der bei Aktivierung des Aktuators erfolgenden Bewegung des Bedienelements auf das Gehäuse wirken,
- wobei der Aktuator versehen ist mit

  - einem ein federelastisches Material, insbesondere Federstahl aufweisenden Trägerstreifen mit einer ersten Außenfläche und einer zweiten Außenfläche,
  - wobei der Trägerstreifen mindestens eine Unterteilungsgruppe aus einem ersten Anbringungsabschnitt, einem zweiten Anbringungsabschnitt und einem zwischen den beiden Anbringungsabschnitten angeordneten ersten Zwischenabschnitt aufweist, wobei der erste Anbringungsabschnitt, der erste Zwischenabschnitt und der zweite Anbringungsabschnitt in Längserstreckung des Trägerstreifens aufeinanderfolgend angeordnet sind,

- wobei der Trägerstreifen bei mehreren in seiner Längserstreckung benachbarten Unterteilungsgruppen zwischen dem zweiten Anbringungsabschnitt der einen Unterteilungsgruppe und dem ersten Anbringungsabschnitt der benachbarten Unterteilungsgruppe einen zweiten Zwischenabschnitt aufweist,

- ersten und zweiten schubsteif mit dem Trägersteifen verbundenen, elektrisch ansteuerbaren Piezo-Elementen, von denen jedes - in Längserstreckung des Trägerstreifens betrachtet - eine Länge aufweist, die ohne elektrische Ansteuerung des Piezo-Elements einen ersten Längenwert und bei elektrischer Ansteuerung einen vom ersten Längenwert verschiedenen zweiten Längenwert annimmt,

- wobei mindestens ein erstes Piezo-Element in einem ersten Anbringungsabschnitt des Trägerstreifens an dessen ersten Außenfläche und mindestens ein zweites Piezo-Element in einem zweiten Anbringungsabschnitt des Trägerstreifens an dessen zweiten Außenfläche angeordnet ist,

- wobei die ersten Zwischenabschnitte und, sofern vorhanden, die zweiten Zwischenabschnitte des Trägerstreifens zwecks Fixierung des Trägerstreifens mit dem Gehäuse mechanisch gekoppelt sind und

- wobei der Trägerstreifen in einem ersten Anbringungsabschnitt (z.B. an seiner zweiten Außenfläche) mechanisch mit dem Bedienelement und in einem zweiten Anbringungsabschnitt (z.B. an seiner ersten Außenfläche) mechanisch mit der Ausgleichsmasse gekoppelt ist und

- einer Ansteuereinheit, mittels derer die Piezo-Elemente zur Überführung des Trägerstreifens aus dessen Ruhezustand, in dem das Bedienelement und die Ausgleichsmasse, die beidseitig des Trägerstreifens angeordnet sind, einen ersten Abstand voneinander aufweisen, unter Verschiebung von Bedienelement und Ausgleichsmasse in entgegengesetzten Richtungen in einen wellenförmigen Aktivierungszustand und zum Überführen des Trägerstreifens aus dem Aktivierungszustand zurück in den Ruhezustand ansteuerbar sind.

Die erfindungsgemäße Bedieneinheit weist ein Gehäuse mit einem Bedienelement auf, das mit einem Bedienfeld versehen ist. Bei dem Bedienelement handelt es sich beispielsweise um einen Touchscreen oder ein Touchpad oder ein Display oder eine Abdeckscheibe eines Touchscreens oder eines Displays (die Oberseiten dieser Bedienelemente bilden Bedienfelder). Das Gehäuse ist in/an dem Gerät befestigbar. Beispielsweise ist das Gehäuse der Bedieneinheit in einer Fahrzeug-Instrumententafel oder in einer Fahrzeug-Mittelkonsole integriert. Das Bedienelement ist in dem Gehäuse elastisch gelagert. Eine manuelle Betätigung des Bedienelements, also eine manuelle Einwirkung auf das Bedienfeld des Bedienelements, wird mittels eines Betätigungssensors (z.B. Touchpanel) erkannt. Dabei wird das Bedienelement vorzugsweise kaum merklich bewegt, wobei der zurückgelegte Weg oder die auf das Bedienelement einwirkende Kraft mittels des Sensors erkannt wird (sogenanntes Force Sense).

Die mechanische Anregung für das aktive haptische Feedback (Force Feedback) erfolgt mit Hilfe eines Aktuators. Vorzugsweise gegensinnig (180° phasenverschoben) zu der Bewegung des Bedienelements wird bei mechanischer Anregung eine Ausgleichsmasse bewegt, die ihrerseits beweglich in/an dem Gehäuse gelagert ist. Die Ausgleichsmasse ist ebenfalls elastisch in dem Gehäuse gelagert.

Erfindungsgemäß wird als Aktuator zur mechanischen Anregung des Bedienelements ein mit Piezo-Elementen versehener Aktuator (nachfolgend der Einfachheit halber Piezo-Aktuator genannt) eingesetzt, wie er oben beschrieben ist. Der erfindungsgemäße Piezo-Aktuator weist einen Trägerstreifen aus einem federelastischen Material auf, das zwei voneinander weg weisende Außenflächen (erste und zweite Außenflächen) aufweist. An beiden Außenflächen befinden sich elektrisch ansteuerbare piezokeramische Elemente (nachfolgend der Einfachheit halber Piezo-Element genannt), die beispielsweise ein- oder mehrlagig ausgebildet sind. Die Piezo-Elemente können also entweder eine oder mehrere Lagen aus Piezo-Keramik aufweisen. Die Piezo-Elemente sind schubstarr bzw. schubsteif mit dem Trägerstreifen verbunden und verändern bei elektrischer Ansteuerung ihre Länge, d.h. ihre Erstreckung in Längsachse des Trägerstreifens betrachtet. Durch die wechselseitige Anordnung der Piezo-Elemente erfährt der Trägerstreifen, der vorzugsweise Federstahl aufweist, ausgehend von seinem Ruhezustand eine Wellenform. Der Ruhezustand kann dabei beispielsweise durch einen gradlinigen Verlauf, oder aber auch durch einen gekrümmten, jedoch nicht wellenförmig gekrümmten Verlauf gekennzeichnet sein. In seinen nicht von den Piezo-Elementen eingenommenen freien Bereichen seiner beiden Außenflächen ist der Trägerstreifen auf seiner einen Seite mechanisch mit dem Bedienelement und auf seiner anderen Seite mechanisch mit der Ausgleichsmasse verbunden. Der Trägerstreifen selbst ist im Gehäuse mechanisch fixiert, wobei er sich innerhalb seiner mit Piezo-Elementen versehenen Bereiche trotz mechanischer Fixierung in dem Gehäuse jeweils halbwellenförmig reversibel verformen lässt.

Der Trägerstreifen weist zumindest eine Unterteilungsgruppe von Abschnitten auf, die einen ersten Anbringungsabschnitt, einen zweiten Anbringungsabschnitt und einen zwischen den beiden Anbringungsabschnitten angeordneten ersten Zwischenabschnitt umfassen. Mehrere derartige Unterteilungsgruppen können vorgesehen sein. Pro Unterteilungsgruppe schließt sich an den ersten Anbringungsabschnitt der erste Zwischenabschnitt und an diesen der zweite Anbringungsabschnitt (in Längserstreckung des Trägerstreifens betrachtet) an. Wenn mehrere derartige Unterteilungsgruppen vorgesehen sind, befindet sich zwischen benachbarten Unterteilungsgruppen ein zweiter Zwischenabschnitt. Im Bereich der ersten und, wenn vorhanden, der zweiten Zwischenabschnitte kann der Trägerstreifen beispielsweise im Gehäuse fixiert sein.

Die Piezo-Elemente sind nun wechselweise an den beiden Außenflächen des Trägerstreifens angeordnet. So befindet sich in einem ersten Anbringungsabschnitt des Trägerstreifens an dessen ersten Außenfläche ein erstes Piezo-Element, während ein zweites Piezo-Element in einem zweiten Anbringungsabschnitt des Trägerstreifens an dessen zweiten Außenfläche angeordnet ist. An den pro Anbringungsabschnitt des Trägerstreifens freien Außenflächen ist der Trägerstreifen beidseitig mit dem Bedienelement und der Ausgleichsmasse mechanisch gekoppelt. So sind beispielsweise die ersten Anbringungsabschnitte des Trägerstreifens an dessen zweiten Außenfläche mechanisch mit dem Bedienelement und die zweiten Anbringungsabschnitte an der ersten Außenfläche des Trägerstreifens mechanisch mit der Ausgleichsmasse gekoppelt.

Alternativ kann der Trägerstreifen innerhalb der Anbringungsabschnitte auch auf denjenigen Außenflächen mit dem Bedienelement bzw. der Ausgleichsmasse verbunden sein, an denen sich die Piezo-Elemente befinden. In diesem Fall liegen also die Verbindungsstellen an dem Trägerstreifen zwischen diesem und Bedienelement bzw. Ausgleichsmasse frei, was beispielsweise dadurch realisierbar ist, dass pro Anbringungsabschnitt beispielsweise zwei beabstandete Piezo-Elemente schubsteif mit dem Trägerstreifen verbunden sind, wobei zwischen den besagten Piezo-Elementen die mechanische Kopplung des Trägerstreifens mit Bedienelement bzw. Ausgleichsmasse erfolgt.

Durch die Ansteuerung der Piezo-Elemente und deren schubsteife Kopplung mit dem Trägerstreifen wird dem Trägerstreifen eine Wellenform verliehen, die dazu führt, dass sich der Abstand, den Bedienelement und Ausgleichsmasse im Ruhezustand des Trägerstreifens voneinander aufeinander aufweisen, bei wellenförmigem Trägerstreifen verändert. Dabei bewegen sich Bedienelement und Trägerstreifen gegensinnig zueinander, und zwar entweder aufeinander zu oder voneinander weg, wenn der Trägerstreifen aus seinem Ruhezustand in seinen wellenförmigen Aktivierungszustand überführt wird. Genau diese gegensinnige Bewegung von Bedienelement und Ausgleichsmasse wird nun erfindungsgemäß genutzt, um nach außen wirkende Momente der Bedieneinheit zu vermeiden (Impulsvermeidung). Das Verhältnis des Bedienelement-Hubes zum Ausgleichsmassen-Hub ist dabei invers zum Verhältnis des Gewichts des Bedienelements zum Gewicht der Ausgleichsmasse. Die unterschiedlichen Hübe können beispielsweise dadurch realisiert werden, dass die Länge der (im typischen Fall jeweils gleich langen) ersten Anbringungsabschnitte des Trägerstreifens verschieden ist von der Länge der (ebenfalls typischerweise gleich langen) zweiten Anbringungsabschnitte. Alternativ oder auch zusätzlich können aber auch unterschiedlich stark sich ausdehnende bzw. sich zusammenziehende Piezo-Elemente in den ersten und zweiten Anbringungsabschnitten verbaut werden.

Der erfindungsgemäße Aktuator hat den Vorteil einer vergleichsweise kleinformatigen und flachen Bauform. Die Teilmassen des Trägerstreifens, die durch die mit der Ausgleichsmasse mechanisch gekoppelten Anbringungsabschnitte repräsentiert werden, können als Beitrag zur Ausgleichsmasse angesehen werden und bilden insoweit eine dem Aktuator inhärente Ausgleichsmasse. Dadurch, dass der Trägerstreifen aus federelastischem Material besteht, ist bereits die elastische Anbindung von Bedienelement und Ausgleichsmasse integraler Bestandteil des Aktuators. Auch die Piezo-Elemente unterstützen die Rückstellfähigkeit des Trägerstreifens. Der erfindungsgemäße Aktuator lässt sich mit Vorteil in den schmalen Zwischenraum zwischen Bedienelement und z.B. Bedienelement-Gehäuserahmen unterbringen. Dieser Bauraum ist im Regelfall eng bemessen und kann mit Hilfe des erfindungsgemäßen "Streifenaktuators" optimal genutzt werden.

Es ist auch möglich, an jeweils zwei parallel zueinander verlaufenden Randabschnitten des Bedienelements einen Aktuator gemäß der Erfindung einzusetzen. Dabei ist allerdings zu beachten, dass der zweite Aktuator keine Ausgleichsmasse aufweist und synchron zum ersten Aktuator dergestalt angeordnet wird, dass einer der Aktuatoren für das haptische Feedback das Bedienelement abstößt, während der andere Aktuator zeitgleich das Bedienelement anzieht. Einer der beiden Aktuatoren wirkt dann noch auf die Ausgleichsmasse, die entweder an dem das Bedienfeld abstoßenden Aktuator vorgesehen ist und ebenfalls abgestoßen wird oder aber an dem das Bedienelement anziehenden Aktuator vorgesehen ist und von dem Aktuator ebenfalls angezogen wird. In beiden Fällen bewegt sich die Ausgleichsmasse dann gegensinnig zu der von den beiden Aktuatoren initiierten Bewegung des Bedienelements.

Mit entsprechenden konstruktiven Maßnahmen (beispielsweise mechanische Verbindung direkt oder indirekt über gegebenenfalls Getriebe) lassen sich die Auslenkungen des Trägerstreifens zu der einen Seite hin auf das Bedienelement und zu der anderen Seite hin auf die Ausgleichsmasse übertragen, was insgesamt der Impulsvermeidung dient. Dabei kann die Masse des Trägerstreifens in denjenigen Auslenkungsabschnitten, die an die Ausgleichsmasse angekoppelt sind, selbst bereits als (Teil der) Ausgleichsmasse aufgefasst werden, die zur Impulsvermeidung benötigt wird. Konstruktionsbedingt fungiert der rückstellfähige Trägerstreifen als Rückstellfeder, so dass zusätzliche Federn entfallen können oder zumindest schwächer dimensioniert sein können.

Auch die Piezo-Elemente selbst fungieren als Federn, da sie sich automatisch nach Beendigung der Ansteuerung in ihren Ruhezustand zurückverformen. Je dicker die Piezo-Elemente ausgeführt sind, desto stärker ist der Rückstelleffekt.

Je nachdem, wie viele einzelne insbesondere Multilayer-Piezo-Keramiken als Piezo-Elemente an dem Trägerstreifen angeordnet werden, ergibt sich ein unterschiedliches Kraft-Weg-Verhältnis des Trägerstreifens. Generell gilt der Zusammenhang: Je mehr einzelne Piezo-Elemente (die dafür umso kürzer werden) eingesetzt werden, desto größer wird die Kraft auf Kosten des Auslenkungshubes. Längere (und dafür weniger) Piezo-Elemente bedeuten mehr Auslenkungshub aber weniger Kraft.

Die mechanische Fixierung des Trägerstreifens des erfindungsgemäßen Aktuators im bzw. am Gehäuse erfolgt in vorteilhafter Weiterbildung der Erfindung zweckmäßigerweise durch erste Montageflansche, die von den beiden Lateralrändern des Trägerstreifens abstehen und winklig, insbesondere rechtwinklig zum Trägerstreifen verlaufen. Bei einer derartigen Ausgestaltung des Aktuators sind im Trägerstreifen an dessen Lateralrändern und/oder an den Montageflanschen Aussparungen vorgesehen, die sich längs der ersten und zweiten Anbringungsabschnitte erstrecken. Im Bereich der ersten Zwischenabschnitte und, sofern vorhanden, auch im Bereich der zweiten Zwischenabschnitte ist der Trägerstreifen mit den Montageflanschen durch Stege verbunden. Durch die abgewinkelten Montageflansche erhält der Trägerstreifen im Bereich seiner Zwischenabschnitte Stabilität, während der auf Grund der Aussparungen dazwischen sich wölben lässt, wenn die Piezo-Elemente angesteuert werden. In den Zwischenabschnitten tordiert der Trägerstreifen, um seinen wellenförmigen Aktivierungszustand einzunehmen. In diesem Zusammenhang sei darauf hingewiesen, dass die Wellenform des Trägerstreifens im Aktivierungszustand derart ist, dass sich der Trägerstreifen elastisch und damit reversibel verformt.

Zur weiteren Stabilität und Fixierung des Trägerstreifens des erfindungsgemäßen Aktuators im Gehäuse können zweite Montageflansche vorgesehen sein, die an den gegenüberliegenden Enden (in Längserstreckung betrachtet) des Trägerstreifens angeordnet sind und ebenfalls winklig, insbesondere rechtwinklig zur Seite des Trägerstreifens verlaufen. Beide zweite Montageflansche können zu einer gemeinsamen Seite des Trägerstreifens oder zu entgegengesetzten Seiten des Trägerstreifens abgewinkelt sein.

In weiterer zweckmäßiger Ausgestaltung der Erfindung kann vorgesehen sein, dass von dem Trägerstreifen zu einer Seite, vorzugsweise zu derjenigen Seite, der gegenüberliegend die Ausgleichsmasse angeordnet ist, Verbindungselemente abstehen, die der Fixierung des Trägerstreifens in/an dem Gehäuse dienen. Diese Verbindungselemente sind beispielsweise nach Art von Knotenblechen, also plattenförmig ausgebildet und erstrecken sich vorzugsweise über die gesamte Breite des Trägerstreifens. Das Ausgleichsgewicht, das beispielsweise als Materialstreifenkörper ausgebildet ist, weist in diesem Fall zweckmäßigerweise Aussparungen auf, durch die hindurch sich die Verbindungselemente mit Spiel erstrecken. Die Ausgleichsmasse kann aber ebenso aus Teilmassen bestehen, die als einzelne (insbesondere massive) Körper zwischen jeweils benachbarten Verbindungselementen angeordnet sind. Durch die Verbindungselemente wird also der Trägerstreifen beispielsweise im Bereich des Gehäuses, in dem dieses parallel zum Randabschnitt des Bedienelements verläuft, fixiert, wobei zwischen Trägerstreifen und Gehäuse die Ausgleichsmasse angeordnet ist. Auf der der Ausgleichsmasse abgewandten Seite des Trägerstreifens befindet sich dann das Bedienelement.

Weitere vorteilhafte Ausgestaltungen der Erfindung sind in den Unteransprüchen angegeben.

Eine Variante der Erfindung sieht einen Aktuator vor, der in einer Bedieneinheit für ein Gerät gemäß obiger Beschreibung verbaut werden kann und versehen ist mit

- einem ein federelastisches Material, insbesondere Federstahl aufweisenden ersten Trägerstreifen mit einer ersten Außenfläche und einer zweiten Außenfläche,

- wobei der erste Trägerstreifen mindestens eine Unterteilungsgruppe mit zwei ersten Anbringungsabschnitten und jeweils einem zwischen diesen angeordneten zweiten Anbringungsabschnitt aufweist, wobei die Anbringungsabschnitte in Längserstreckung des ersten Trägerstreifens aufeinanderfolgend angeordnet sind,

- einem parallel zum ersten Trägerstreifen verlaufenden, ein federelastisches Material, insbesondere Federstahl aufweisenden zweiten Trägerstreifen mit einer der ersten Außenfläche des ersten Trägerstreifen zugewandten ersten Außenfläche und einer der ersten Außenfläche des ersten Trägerstreifens abgewandten zweiten Außenfläche,

- wobei der zweite Trägersteifen mindesten eine Unterteilungsgruppe mit zwei ersten Anbringungsabschnitten und einem zwischen diesen angeordneten zweiten Anbringungsabschnitt aufweist, wobei die Anbringungsabschnitte in Längserstreckung des zweiten Trägerstreifens aufeinanderfolgend angeordnet sind,

- einem Verbindungselement, mittels dessen die beiden Trägerstreifen untereinander verbunden sind und das zur Fixierung der beiden Trägerstreifen mit dem Gehäuse verbunden ist, wobei das Verbindungselement erste Anbringungsabschnitte des ersten Trägerstreifens an dessen ersten Außenfläche mit ersten Anbringungsabschnitten des zweiten Trägerstreifens an dessen ersten Außenfläche verbindet,

- ersten und zweiten schubsteif mit den beiden Trä-

gerstreifen verbundenen, elektrisch ansteuerbaren Piezo-Elemente, von denen jedes - in Längserstreckung des Trägerstreifens betrachtet - eine Länge aufweist, die ohne elektrische Ansteuerung des Piezo-Elements einen ersten Längenwert und bei elektrischer Ansteuerung einen vom ersten Längenwert verschiedenen zweiten Längenwert annimmt,

- wobei in jedem ersten Anbringungsabschnitt des ersten Trägerstreifens an dessen zweiter Außenfläche mindestens ein erstes Piezo-Element angeordnet ist sowie in jedem zweiten Anbringungsabschnitt des ersten Trägerstreifens an dessen erster Außenfläche mindestens ein zweites Piezo-Element angeordnet ist und wobei in jedem ersten Anbringungsabschnitt des zweiten Trägerstreifens an dessen zweiter Außenfläche mindestens ein erstes Piezo-Element sowie in jedem zweiten Anbringungsabschnitt des zweiten Trägerstreifens an dessen erster Außenfläche mindestens ein zweites Piezo-Element angeordnet ist und

- wobei der erste Trägerstreifen (z.B. an seiner zweiten Außenfläche) in jedem zweiten Anbringungsabschnitt mechanisch mit dem Bedienelement und der zweite Trägerstreifen (z.B. an seiner zweiten Außenfläche) in jedem zweiten Anbringungsabschnitt mechanisch mit der Ausgleichsmasse gekoppelt ist,

- wobei eine Ansteuereinheit vorgesehen ist, mittels derer die Piezo-Elemente zur Überführung beider Trägerstreifen aus deren jeweiligem Ruhezustand, in dem das Bedienelement und die Ausgleichsmasse, die sich beidseitig der Anordnung aus den beiden Trägerstreifen und dem Verbindungselement befinden, einen ersten Abstand voneinander aufweisen, unter Verschiebung von Bedienelement und Ausgleichsmasse in entgegengesetzten Richtungen in einen wellenförmigen Aktivierungszustand, in dem Bedienelement und Ausgleichsmasse einen vom ersten Abstand verschiedenen zweiten Abstand voneinander aufweisen, und zum Überführen der Trägerstreifen aus deren jeweiligem Aktivierungszustand zurück in deren jeweiligen Ruhezustand ansteuerbar sind.

Während der weiter oben beschriebene Aktuator gemäß der ersten Variante der Erfindung einen einzigen Trägerstreifen aufweist, ist der Aktuator gemäß der vorstehend beschriebenen zweiten Variante der Erfindung mit zwei Trägerstreifen versehen, die untereinander mit Hilfe eines Verbindungselements verbunden sind. Jeder Trägerstreifen ist, wie oben im Zusammenhang mit dem Einzelstreifenaktuator beschrieben, beidseitig und wechselweise mit ersten und zweiten Piezo-Elementen versehen. Die beiden Trägerstreifen sind parallel zueinander angeordnet und können beispielsweise symmetrisch zur Längsachse des zwischen beiden Trägerstreifen verlaufenden Verbindungselements angeordnet sein. Beide Trägerstreifen können durch Ansteuerung der Piezo-Elemente aus dem Ruhezustand in einen wellenförmigen Aktivierungszustand überführt werden. Die Anordnung aus den beiden Trägerstreifen und dem Verbindungselement befindet sich zwischen Bedienelement und Ausgleichsmasse, so dass sich bei Ansteuerung der Piezo-Elemente der Abstand zwischen Bedienelement und Ausgleichsmasse verändert (und zwar vergrößert oder verkleinert). Damit einher geht demzufolge eine gegensinnige Verschiebebewegung von Bedienelement und Ausgleichsmasse. Auch ein derartiger Piezo-Doppelstreifenaktuator kann zweifach verbaut werden, wobei auch hier gilt, dass einer der beiden Aktuatoren keine Ausgleichsmasse aufweist. In diesem Zusammenhang sei verwiesen auf die obige Beschreibung der doppelten Anordnung eines Piezo-Einzelstreifenaktuators an parallelen, gegenüberliegenden Rändern des Bedienelements.

In vorteilhafter Weise kann vorgesehen sein, dass jeder Trägerstreifen mindestens eine weitere Unterteilungsgruppe aufweist, die einen ersten Anbringungsabschnitt und einen zweiten Anbringungsabschnitt aufweist, der neben einem ersten Anbringungsabschnitt einer benachbarten Unterteilungsgruppe angeordnet ist, dass das Verbindungselement die beiden Trägerstreifen an deren in dem jeweiligen ersten Anbringungsabschnitt jeder weiteren Unterteilungsgruppe verbindet, dass das Bedienelement mit dem ersten Trägerstreifen an dessen zweiter Außenfläche in den zweiten Anbringungsabschnitt jeder weiteren Unterteilungsgruppe und die Ausgleichsmasse mit dem zweiten Trägerstreifen an dessen zweiter Außenfläche in den ersten Anbringungsabschnitt jeder weiteren Unterteilungsgruppe mechanisch gekoppelt ist und dass an der zweiten Außenfläche jedes Trägerstreifens in dem ersten Anbringungsabschnitt jeder weiteren Unterteilungsgruppe ein erstes Piezo-Element und an der ersten Außenfläche jedes Trägerstreifens in den zweiten Anbringungsabschnitt jeder weiteren Unterteilungsgruppe ein zweites Piezo-Element schubsteif mit dem betreffenden Trägerstreifen verbunden ist.

Auch für die zweite Variante des erfindungsgemäßen Aktuators gilt, dass die mechanische Verbindung des einen Trägerstreifens mit dem Bedienelements und des anderen Trägerstreifens mit der Ausgleichsmasse sowie die mechanische Verbindung beider Trägerstreifen mit dem Verbindungselement in den einzelnen Anbringungsabschnitten auf denjenigen Außenflächen der beiden Trägerstreifen erfolgen kann, die entweder keine Piezo-Elemente aufweisen oder aber mit Piezo-Elementen besetzt sind. Auch bezüglich dieser verschiedenen möglichen Ausgestaltungen der mechanischen Ankopplung des Aktuators wird auf die Ausführungen im Zusammenhang mit dem Piezo-Einzelstreifenaktuator verwiesen.

Die Wellenform des Trägerstreifens wird erfindungsgemäß mittels der Piezo-Elemente realisiert, die wechselweise und aufeinanderfolgend auf beiden Außenflächen des Trägerstreifens schubsteif, z.B. festgeklebt sind. Durch Längenausdehnung der Piezo-Elemente bei deren Ansteuerung wird dem Trägerstreifen eine Wellenform verliehen. Dabei verformen sich sowohl die Piezo-Elemente als auch der Trägerstreifen elastisch, weshalb die Ausprägung der Wellenform nur gering ist, was aber, nachdem das Bedienelement für das haptische Feedback nur im 1/10 mm-Bereich angeregt wird, ausreichend ist.

Die Piezo-Elemente können auch sämtlich auf einer der beiden Außenflächen des Trägerstreifens angeordnet sein. Dann müsste aber jedes zweite Piezo-Element sich in seiner Länge vergrößern und die anderen Piezo-Elemente sich in ihrer Länge verkürzen, um dem Trägerstreifen im Aktivierungszustand seine Wellenform zu verleihen.

Gemäß einer weiteren Variante der Erfindung ist der Aktuator als ein Piezo-Aktuator ausgebildet und weist der Aktuator ein elektrisch anregbares Piezokeramikelement sowie ein mechanisches Getriebe zum Umsetzen einer Längenausdehnung (mit anschließender Längenverkürzung) des Piezokeramikelements in eine Bewegung des Bedienfeldes auf, wobei das mechanische Getriebe mindestens ein das Ausgleichsgewicht und/oder ein Teil des Ausgleichsgewichts und/oder die elastische Lagerung des Bedienfeldes bildendes Getriebeelement und mindestens ein die elastische Lagerung des Bedienfeldes bildendes weiteres Getriebeelement aufweist.

Die Erfindung wird nachfolgend anhand verschiedener Ausführungsbeispiele sowie unter Bezugnahme auf die Zeichnung näher erläutert. Im Einzelnen zeigen dabei:

Fig. 1 schematisch die bei einer Bedieneinheit mit aktivem haptischen Feedback auftretenden Kräfte,

Fig. 2 eine schematische Darstellung der auftretenden Kräfte bei erfindungsgemäßer Verwendung eines Gegengewichts als Ausgleichsmasse,

Fig. 3 zur Erläuterung des Momentenausgleichs schematisch eine Konstruktion eines gegenkraftkompensierten haptischen Feedback bei einer Bedieneinheit, wobei der Aktuator hinsichtlich seiner Konstruktion noch nicht näher spezifiziert ist,

Fign. 4 und 5 weitere Prinzip-Skizzen zur Erläuterung der Erfindung,

Fig. 6 eine Draufsicht auf eine Bedieneinheit mit Gehäuse und Gehäuserahmen, wobei längs eines Randabschnitts des Gehäuserahmens zwischen diesem und dem Bedienelement ein erfindungsgemäße Aktuator angeordnet ist,

Fig. 7 einen Schnitt entlang der Linie VII-VII der Fig. 6 bzw. der Fig. 9,

Fig. 8 eine perspektivische Explosionsdarstellung des Aufbaus des Aktuators und dessen Anordnung zwischen Bedienelement und Gehäuserahmen,

Fig. 9 einen Schnitt entlang der Linie IX-IX der Fig. 7, wobei der Aktuator so, wie auch in Fig. 8, in seinem Ruhezustand gezeigt ist,

Fig. 10 eine Schnittansicht ähnlich der gemäß Fig. 9, jedoch im Aktivierungszustand des Aktuators,

Fig. 11 eine perspektivische Explosionsdarstellung ähnlich der gemäß Fig. 8, wobei ein Aktuator gemäß einem zweiten Ausführungsbeispiel gezeigt ist,

Fig. 12 eine Schnittansicht ähnlich der gemäß Fig. 9, jedoch im Ruhezustand des Aktuators, wie er in Fig. 11 gezeigt ist,

Fig. 13 eine Schnittansicht ähnlich der gemäß Fig. 10, jedoch mit dem Aktuator, wie er in Fig. 11 gezeigt ist, und zwar im Aktivierungszustand,

Fig. 14 eine perspektivische Explosionsdarstellung ähnlich der gemäß den Fign. 8 und 11, jedoch mit einem Aktuator gemäß einem weiteren Ausführungsbeispiel der Erfindung,

Fig. 15 eine Schnittansicht ähnlich der in den Fign. 9 bzw. 12, und zwar mit dem Aktuator, wie er in Fig. 14 gezeigt ist, im Ruhezustand,

Fig. 16 eine Schnittansicht ähnlich der in den Fign. 10 bzw. 13, wobei sich der in Fig. 14 gezeigte Aktuator in seinem Aktivierungszustand befindet,

Fign. 17 und 18 Schnittansichten, bei denen ein Aktuator gemäß einem weiteren Ausführungsbeispiel der Erfindung gezeigt ist, und zwar im Ruhezustand (Fig. 17) und im Aktivierungszustand (Fig. 18), und

Fign. 19 und 20 Schnittansichten durch den Randbereich der Bedieneinheit unter Verwendung eines Aktuators gemäß einem weiteren Ausführungsbeispiel, wobei dieser Aktuator im Ruhezustand (Fig. 19) und im Aktivierungszustand (Fig. 20) gezeigt ist.

Hinsichtlich der zeichnerischen Darstellung der Aktuatoren bzw. der Trägerstreifen der Aktuatoren in deren Aktivierungszustand sei vorab erwähnt, dass in den Figuren die Wellenform stark übertrieben gezeichnet ist, um das erfindungsgemäße Prinzip deutlicher herauszustellen.

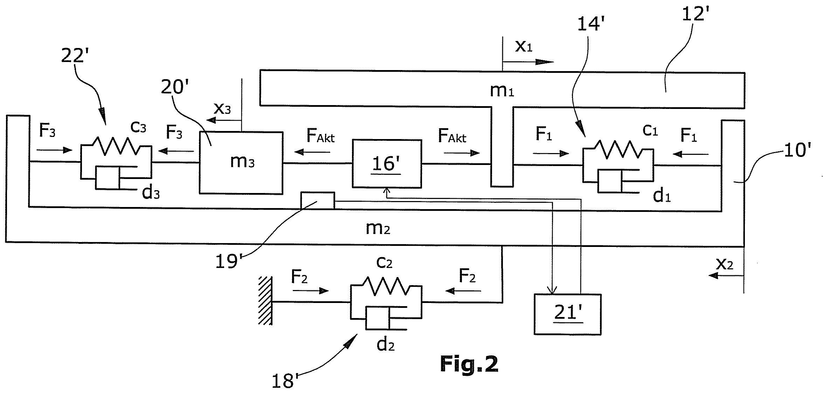

Erfindungsgemäß wird die Verwendung einer elastisch gelagerten (siehe Feder-Masse-Dämpfungssystem 22') beweglichen Ausgleichsmasse 20' zwischen dem Aktuator 16' und dem Gehäuse 10' zum Ausgleich der auf das Gehäuse 10' wirkenden Kräfte vorgeschlagen (Fig. 2). Die Betätigung des Bedienelements 12' wird mittels des Betätigungssensors 19' erkannt. Daraufhin wird über eine Auswerte- und Ansteuereinheit 21', die Signale vom Betätigungssensor 19' empfängt und Ansteuersignale an den Aktuator 16' sendet, der Aktuator 16' angesteuert.

Bei entsprechender Auslegung des zusätzlichen Feder-Masse-Dämpfungssystems 22' bzw. $c_3$, $d_3$, $m_3$ kann die auf das Fahrzeug wirkende, resultierende Kraft $F_2(t)$ eliminiert werden (die durch Gravitation entstehenden statischen Kräfte spielen bei der Entstehung von Geräuschen bzw. Vibrationen keine Rolle).

Für eine beliebig vorgegebene Displayauslenkung $x_1(t)$ kann die Auslenkung $x_2(t)$/Bewegung des Gerätegehäuses und somit auch die Kraft $F_2(t)$ auf die Gerätebefestigung unter folgenden Bedingungen eliminiert werden:

$$c_3 = c_1 \frac{m_3}{m_1}, \qquad d_3 = d_1 \frac{m_3}{m_1}$$

Daraus ergibt sich die Auslenkung der Ausgleichsmasse 20':

$$x_3(t) = x_1(t) \frac{m_1}{m_3}$$

Unter diesen Bedingungen hat auch die Elastizität der Gerätebefestigung 18' keinen Einfluss auf das haptische Feedback. Die Ausgleichsmasse 20' bzw. $m_3$ ist in der Regel durch die Bauraumvorgaben eingeschränkt und ist kleiner als die Displaymasse $m_1$. Idealerweise kann sie als ein Teil des Aktuators 16' ausgeführt werden.

Die vorliegende Erfindung ermöglicht es

-   ein haptisches Feedback auf massebehafteten Oberflächen ohne dynamische Impulseinwirkung auf die Umgebung zu erzeugen.

-   ein haptisches Feedback in einem Bediengerät zu erzeugen, das unabhängig von der Elastizität der Gerätebefestigung ist.

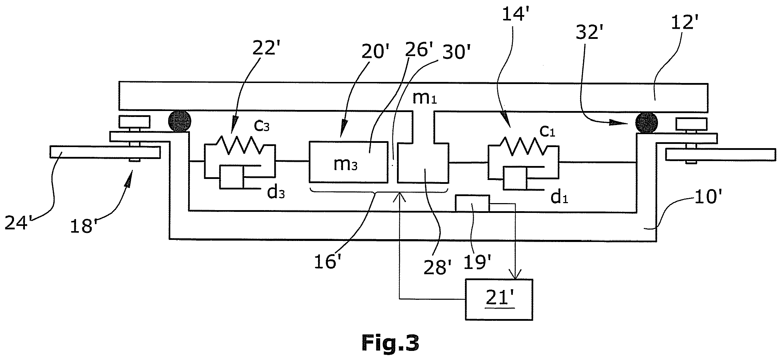

In Fig. 3 ist zur Erläuterung der zur Impulsvermeidung bei Bedieneinheiten mit aktivem haptischen Feedback ergreifenden Maßnahmen eine Vorrichtung mit einem gegenkraftkompensierten haptischen Feedback skizziert.

Im dargestellten Beispiel ist der Aktuator 16' als Zugankerelektromagnet ausgebildet und weist ein am Gehäuse 10' elastisch gelagertes Statorblechpaket mit Aktuatorspule, d.h. einen Stator 26' und einem am Bedienelement 12' fest angebundenes Ankerblechpaket, d. h. einen Anker 28' auf. Der Stator 26' bildet die bewegliche Ausgleichsmasse 20' bzw. weist diese auf. Bei der Einstellung des bei 30' gezeigten Luftspalts im Zugankerelektromagnet muss die maximale Auslenkung des Bedienelements 12' und der Ausgleichsmasse 20' zueinander berücksichtigt werden. Der Stator 26' ist elastisch (Feder-Masse-Dämpfungssystem 22') am Gehäuse 10' gelagert, kann aber auch stattdessen am Bedienelement 12' elastisch angebunden sein. Die Bedienelementführung ist bei 32' angedeutet. Das Gehäuse 10' ist am Fahrzeug 24' (z.B. an dessen Instrumententafel) befestigt.

Wie sich aus dem Vorstehenden ergibt, wird zur Impulsvermeidung beim haptischen Feedback zusätzlich zur eigentlich zu bewegenden Displayeinheit bzw. zusätzlich zu dem eigentlich zu bewegenden Bedienfeld eine gegenüber dem starren Gehäuse der Bedieneinheit beweglich (und federnd) gelagerte Ausgleichsmasse bewegt. Durch geeignete Wahl von Weg, Masse, Dämpfung und Federkonstante dieser Ausgleichsmasse kann ein Impulseintrag des Gesamtsystems auf die Fahrzeugkarosserie vermieden werden.

Je geringer das Gewicht des mit aktivem haptischen Feedback versehenen Bedienelements ist, umso weniger Ausgleichsmasse für die Impulsvermeidung muss gegensinnig zum Bedienelement bewegt werden. Als geringgewichtiges Bedienelement kommt z.B. das Touchpanel eines Touchscreens oder dessen Abdeckscheibe (Coverglas) in Frage, wozu diese Elemente relativ zum Display beweglich angeordnet sein müssen.

Ist der für die Auslenkung verantwortliche Aktuator als Piezo (im Speziellen mit mechanischer Übersetzung) realisiert, bietet sich die Möglichkeit die zusätzlich erforderlichen Komponenten Ausgleichsmasse, Feder und Dämpfer in den Aktuator zu integrieren und so zusätzliche Bauteile einzusparen.

Ein Vorteil der Erfindung ist die geschickte Ausnutzung ohnehin vorhandener mechanischer Eigenschaften piezokeramischer Materialien, insbesondere im Hinblick auf nach außen hin impulsfreies haptisches Feedback. Dadurch lassen sich sowohl Kosten als auch Bauraum einsparen.

Um nennenswerte Auslenkungen und Kräfte bei Piezo-Aktuatoren für haptisches Feedback zu erzielen, bestehen diese aus mehreren Keramiklagen, die durch Elektroden voneinander getrennt sind. Dennoch sind die Auslenkungen in der Regel zu gering, um sie ohne Weiteres zur Erzeugung von haptischem Feedback zu verwenden.

Man kann sich mechanischer Hebel bedienen, die durch ein Übersetzungsverhältnis gekennzeichnet sind. So kann auf Kosten einer niedrigeren Auslenkung des Aktuators seine Kraftwirkung erhöht werden, oder andersherum. Diese Hebel bestehen oft aus biegbaren Materialien (z.B. Metall), die an die eigentlichen Piezo-Keramiken angebracht werden.

Piezo-Keramiken sind zumeist so ausgelegt, dass sie bei zunehmender Auslenkung eine zunehmende Rückstellkraft erzeugen. Mechanisch betrachtet stellen sie daher, neben ihrer Funktion als Übersetzung, Federn dar, auf deren Federsteifigkeit c konstruktionsmäßig Einfluss genommen werden kann. Ebenso kann ihre Masse m variiert werden, z.B. durch Erhöhung des Volumens oder durch geeignete Wahl des Materials. Die Dämpfung d ergibt sich dann entsprechend aus den verwendeten Materialien und der gewählten Geometrie. Verglichen mit der in Fig. 2 dargestellten Skizze können die Bauteile c3, d3 und m3 daher als Teil des Aktuators aufgefasst werden. Nach wie vor müssen die Parameter zur Impulsvermeidung die folgenden Gleichungen erfüllen:

$$c_3 = c_1 \frac{m_3}{m_1}, d_3 = d_1 \frac{m_3}{m_1}$$

Zu beachten ist nun, dass sich die Wege x_3 und x_1, für die bei Einhaltung obiger Gleichung die Beziehung

$$x_3 = x_1 \frac{m_3}{m_1}$$

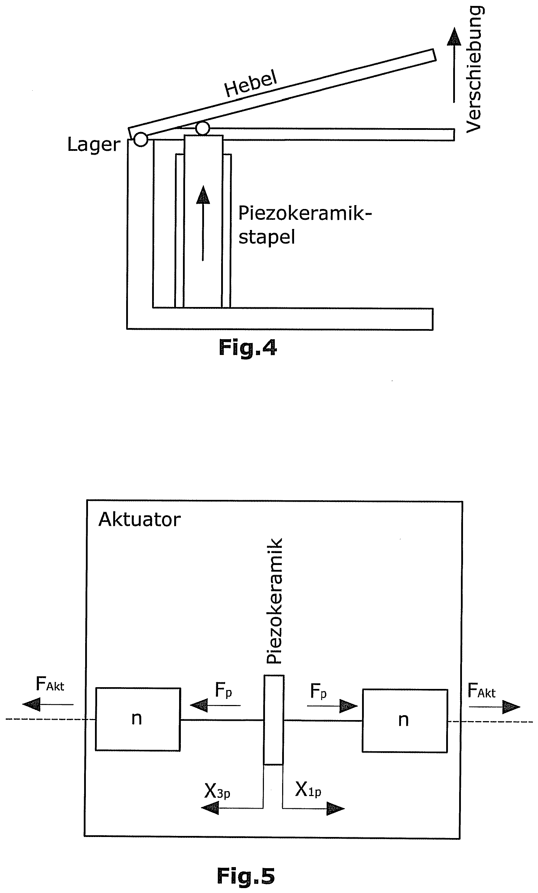

gilt, sowie die Kraft $F_{Akt}$ nicht mehr direkt aus dem Kraft-Weg-Diagramm des Piezo bestimmen lässt. Stattdessen müssen sie unter Berücksichtigung des mechanischen Übersetzungsverhältnisses n aus den Größen direkt am Piezo (indiziert mit P) ermittelt werden (vgl. Fig. 5).

Damit gilt:

$$x_3 = n \cdot x_{3P}, x_1 = n \cdot x_{1P}$$

$$F_{Akt} = \frac{1}{n} F_P$$

Ausgehend von Fig. 2 werden die mechanischen Komponenten m3, c3 und d3 sowie n aus Fig. 5 durch den Hebel (Lever) aus Fig. 4 (zumindest teilweise) realisiert.

Die mechanische Übersetzung kann darüber hinaus dazu verwenden werden, die Kraftrichtung umzulenken. Bauraumbedingt kann es erforderlich sein, die (gestapelte) Piezo-Keramik so zu positionieren, dass ihre Hauptauslenkungsrichtung nicht mit der Richtung des gewünschten haptischen Feedbacks übereinstimmt. Ganz allgemein betrachtet, kann dieser Nachteil durch geeignete Wahl des Hebelkonzepts ausgeglichen werden.

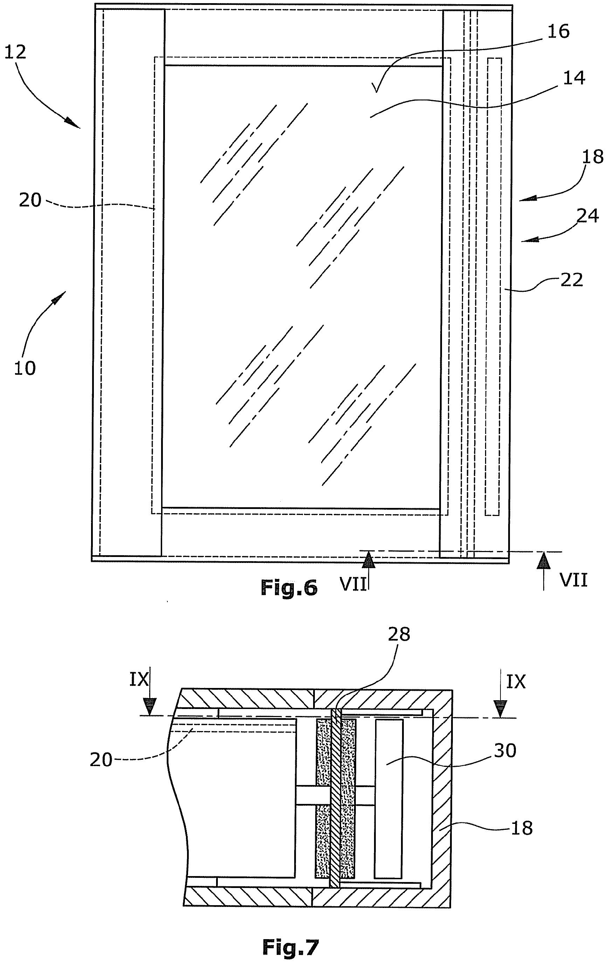

Anhand der Fign. 6 bis 10 wird nachfolgend eine Bedieneinheit mit einem ersten Ausführungsbeispiel eines Piezo-Streifenaktuators gemäß der Erfindung erläutert.

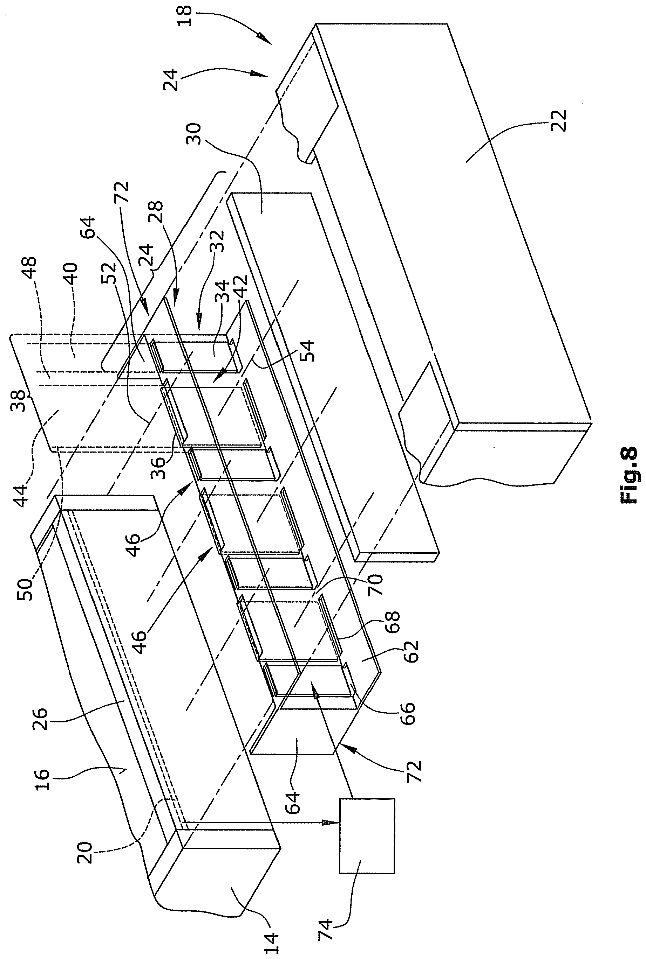

In Fig. 6 ist in Draufsicht sowie in Fig. 7 als Teilschnittansicht eine Bedieneinheit 10 mit einem Gehäuse 12 sowie einem Bedienelement 14 mit Bedienoberfläche 16 gezeigt, um die herum der Rahmen 18 des Gehäuses verläuft. Bei der Bedieneinheit 10 handelt es sich in diesem Ausführungsbeispiel um einen Touchscreen mit beispielsweise kapazitivem Touchpanel als Betätigungssensor 20 (siehe beispielsweise auch Fign. 7 und 8), wobei anzumerken ist, dass die Betätigungssensorik auch durch einen Weg- bzw. Kraftsensor realisiert sein könnte oder ein derartiger Weg- bzw. Kraftsensor zusätzlich zum Touchpanel vorgesehen sein kann. Es ist also möglich, dass eine valide Betätigung des Bedienelements 14 eine geringfügige Niederdrückbewegung des Bedienelements 14 voraussetzt. Für die Erfindung, nämlich die Ausgestaltung des Aktuators für das aktive haptische Feedback hat dies untergeordnete Bedeutung.

Wie in Fig. 6 angedeutet, befindet sich im Rahmenabschnitt 22 ein Aktuator 24, der zwischen dem Rahmen 18 und dem dazu parallel verlaufenden Randabschnitt 26 des Bedienelements 14 angeordnet ist. Einzelheiten des Aktuators 24 sind in den Fign. 7 bis 10 gezeigt.

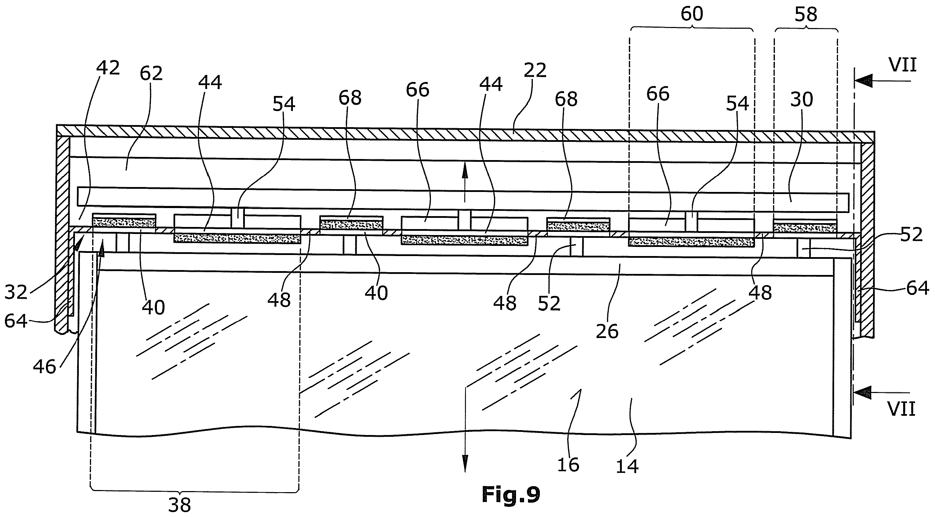

Der Aktuator 24 weist gemäß Fig. 8 einen im Gehäuse fixierten Trägerkörper 28 sowie eine Ausgleichsmasse 30 auf, die in diesem Ausführungsbeispiel als Streifenmaterialkörper ausgebildet ist. Der Trägerkörper 28 weist seinerseits einen Trägerstreifen 32 aus einem flexiblen Material, beispielsweise Federstahl, auf, an dem beidseitig und in ihrer Aufeinanderfolge längs der Längserstreckung des Trägerstreifens 32 wechselweise erste und zweite Piezo-Elemente 34,36 angeordnet sind. Gedanklich lässt sich der Trägerstreifen 32 in in diesem Ausführungsbeispiel drei aufeinanderfolgende Unterteilungsgruppen 38 unterteilen, die jeweils einen ersten Anbringungsabschnitt 40, in dem ein erstes Piezo-Element 34 auf der ersten Außenfläche 42 des Trägerstreifens 32 angeordnet ist, und einen zweiten Anbringungsabschnitt 44 umfasst, in dem auf der zweiten Außenfläche 46 des Trägerstreifens 32 ein zweites Piezo-Element 36 angeordnet ist. Zwischen den beiden Anbringungsabschnitten 40 und 44 befindet sich ein erster Zwischenabschnitt 48. Zwischen benachbarten Unterteilungsgruppen 38 befindet sich ein zweiter Zwischenabschnitt 50 des Trägerstreifens 32. Im Bereich der ersten Anbringungsabschnitte 40 ist der Trägerstreifen 32 an seiner zweiten Außenfläche 46 mechanisch mit dem Bedienelement 14 verbunden (siehe die Bedienelement-Verbindungselemente 52 in Fig. 9, die auch in Fig. 8 angedeutet sind), während der Trägerstreifen 32 an seiner ersten Außenfläche 42 im Bereich der zweiten Anbringungsabschnitte 44 über Ausgleichsmasse-Verbindungselemente 54 mit der Ausgleichsmasse 30 mechanisch gekoppelt ist.

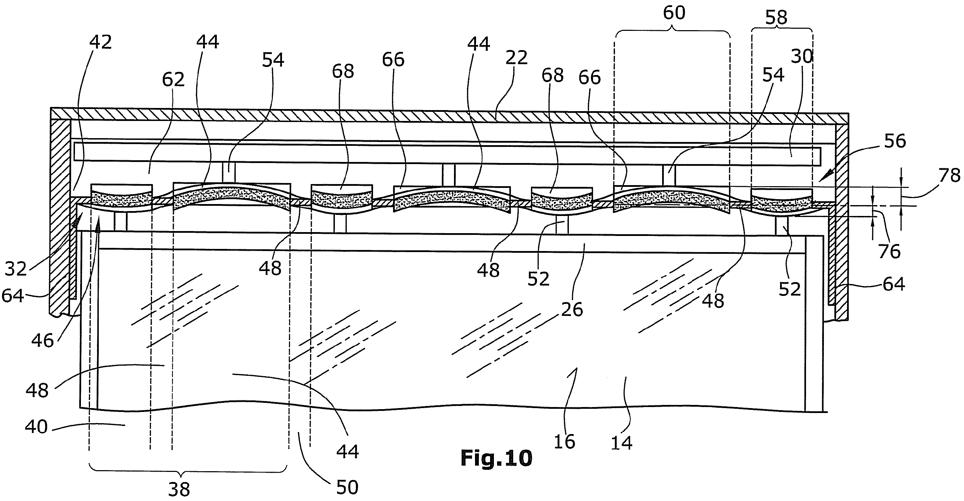

Der Trägerstreifen 32 ist, wie bereits oben erwähnt, elastisch, lässt sich also verbiegen. Diese Verbiegung des Trägerstreifens 32 wird durch Ansteuerung der Piezo-Elemente 34,36 bewirkt. Diese Piezo-Elemente 34,36 verändern bei Ansteuerung ihre Länge, d.h. ihre Erstreckung in Längsrichtung des Trägerstreifens 32. Dadurch nimmt der Trägerstreifen 32 ausgehend von seinem in den Fig. 8 und 9 gezeigten Ruhezustand im Aktivierungszustand die Wellenform 56 an, wie sie in Fig. 10 gezeigt ist. Dabei setzt sich die Wellenform 56 aus ersten Halbwellen 58 und zweiten entgegengesetzt gerichteten Halbwellen 60 zusammen.

Die Fixierung des Trägerkörpers 28 erfolgt durch erste Flansche 62 sowie zweite Flansche 64. Die ersten Flansche 62 sind längs der Lateralränder des Trägerstreifens 32 angeordnet und über die erste Außenfläche 42 hinaus insbesondere rechtwinklig abgewinkelt. Längs der Lateralränder erstrecken sich in den ersten Montageflanschen 62 oder aber auch (gegebenenfalls zusätzlich) im Trägerstreifen 32 Aussparungen 66,68, und zwar innerhalb der Bereiche der ersten Anbringungsabschnitte 40 bzw. der zweiten Anbringungsabschnitte 44. In den ersten und zweiten Zwischenabschnitten 48,50 bilden sich dann zwischen benachbarten Aussparungen 66,68 Stege 70, über die die ersten Montageflansche 62 mit dem Trägerstreifen 32 verbunden sind. An den in Längserstreckung gegenüberliegenden Enden 72 des Trägerstreifens 32 sind die zweiten Montageflansche 64 angeordnet, die ebenfalls vorzugsweise rechtwinklig abgewinkelt sind, und zwar in diesem Ausführungsbeispiel über die zweite Außenfläche 46 hinaus. Durch die Montageflansche 62,64 ist der Trägerkörper 28 an der Innenseite des Rahmens 18 fixiert. Die Aussparungen 66,68 ermöglichen die wellenförmige Verformung des Trägerstreifens 32, der durch die Stege 70 in den Zwischenabschnitten 48,50 beweglich an den Montageflanschen 62 angebunden ist.

In Fig. 8 ist zusätzlich noch eine Ansteuereinheit 74 gezeigt, die von der Betätigungssensorik 20 ein Signal empfängt, um dann die Piezo-Elemente 34,36 anzusteuern. Das Bedienelement 14 und Ausgleichsmasse 30 werden synchron in entgegengesetzten Richtungen bewegt, wenn der Trägerstreifen 32 aus seiner Ruheposition (siehe Fig. 9) in seine Aktivierungsposition (siehe Fig. 10) überführt wird.

In Fig. 10 ist gezeigt, dass die Amplitude 76 der ersten Halbwelle 58 kleiner ist als die Amplitude 78 der zweiten Halbwelle 60 der Wellenform 56 des Trägersteifens 32 in dessen Aktivierungszustand. Der Hub, den das Bedienelement 14 erfährt, ist also kleiner als der Hub der Ausgleichsmasse 30. Für die Impulskompensation gilt, dass die kinetische Energie, die für das Bedienelement 14 aufgewendet wird, gleich der kinetischen Energie sein sollte, die für die Ausgleichsmasse 30 aufgebracht wird. Beide bewegen sich in entgegengesetzten Richtungen, was bedeutet, dass bei größerem Ausgleichsmassenhub 78 die Ausgleichsmasse 30 ein entsprechend geringeres Gewicht als das Bedienelement 14 aufweist.

In den Fig. 9 und 10 ist zu erkennen, dass das Bewegungskonzept für Bedienelement 14 und Ausgleichsmasse 30 auf dem "Abstoßungsprinzip" beruht. Bedienelement 14 und Ausgleichsmasse 30 bewegen sich für die Impulskompensation voneinander weg, wenn der Trägerstreifen 32 in seinen Aktivierungszustand überführt wird, und wenn der Trägerstreifen 32 aus seinem Aktivierungszustand wieder in seinen Ruhezustand überführt wird. In beiden Fällen werden die auf Grund der Bewegung des Bedienelements 14 nach außen wirkenden Kräfte kompensiert (Impulsvermeidung).

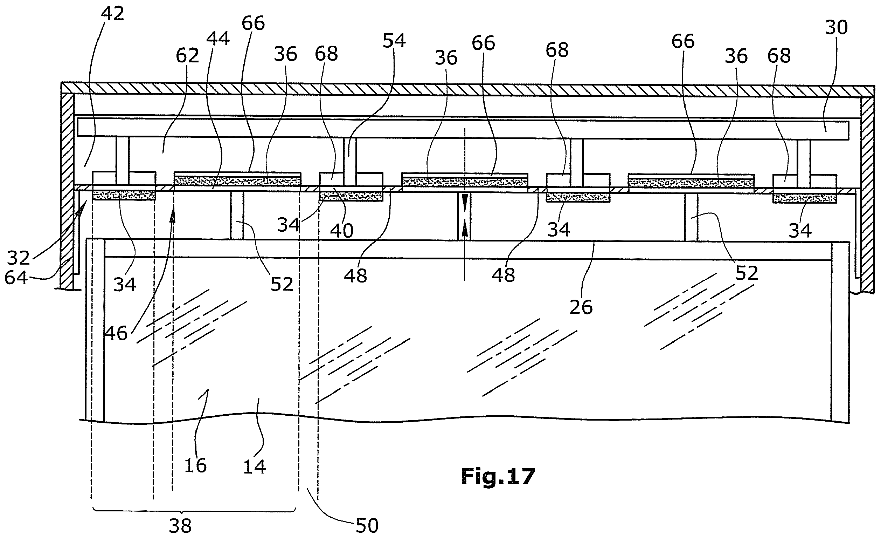

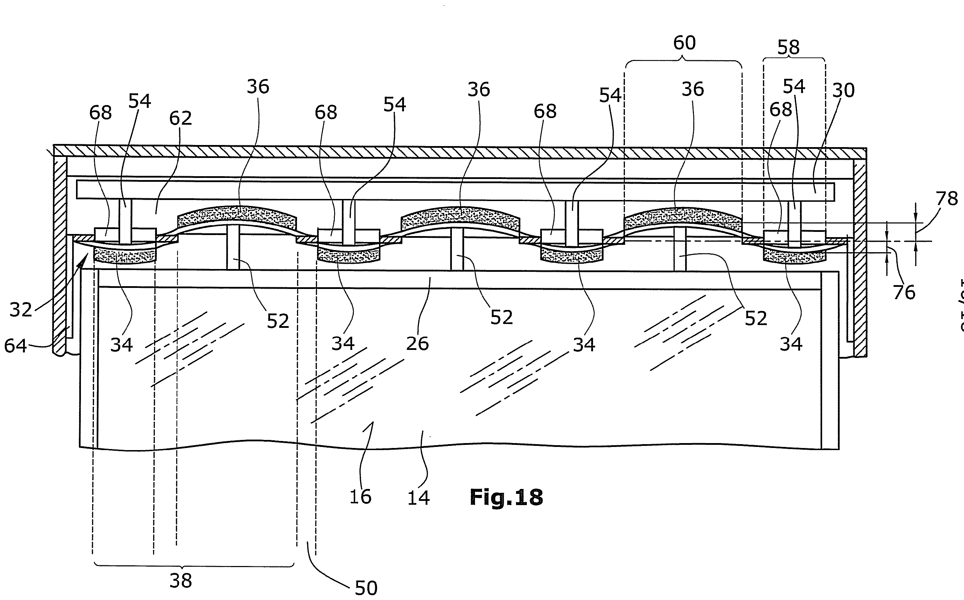

In den Fig. 17 und 18 ist das Bewegungsprinzip des Aktuators 24b umgekehrt. Hierzu ist die wechselweise Anordnung der Piezo-Elemente 34,36 und die mechanische Kopplung von Bedienelement 14 und Ausgleichsmasse 30 mit dem Trägerstreifen 32 vertauscht, was die Anordnung der zuvor genannten Elemente an den Außenflächen des Trägerstreifens 32 betrifft. Dadurch bewegen sich nun Bedienelement 14 und Ausgleichsmasse 30 aufeinander zu, wenn der Trägerstreifen 32 in seinen Aktivierungszustand überführt wird, und dementsprechend voneinander weg, wenn er aus dem Aktivierungszustand wieder in den Ruhezustand überführt wird.

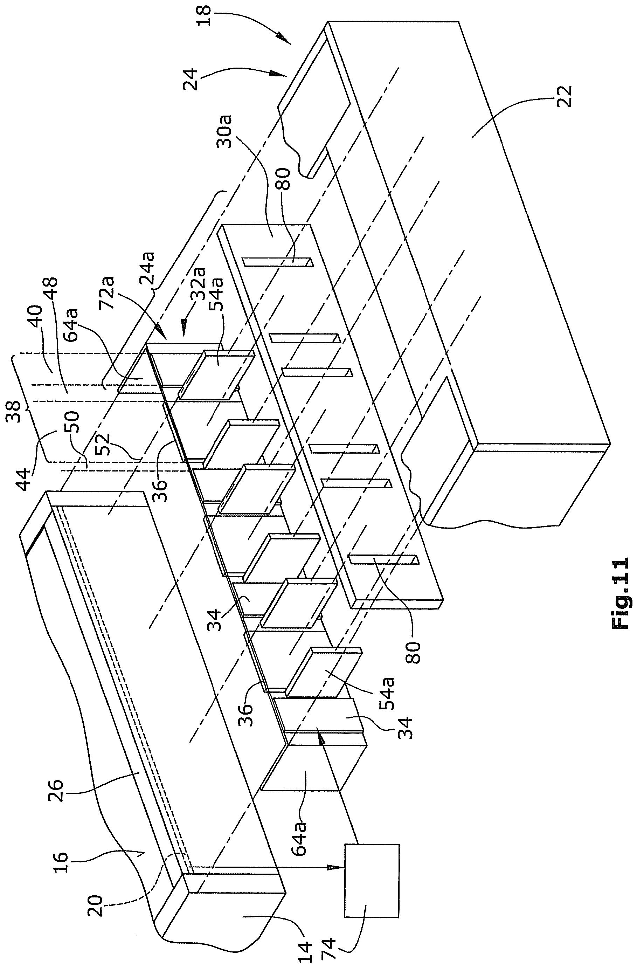

In den Fig. 11 bis 13 ist ein Aktuator 24a gemäß einem zweiten Ausführungsbeispiel gezeigt. Soweit die Elemente des Aktuators 24a denjenigen des Aktuators 24 der Fign. 8 bis 10 konstruktiv bzw. funktional gleichen bzw. entsprechen, sind sie in den Fign. 11 bis 13 mit den gleichen Bezugszeichen wie in den Fign. 8 bis 10 bezeichnet bzw. mit den gleichen um den Buchstaben a ergänzten Bezugszeichen bezeichnet.

Der Aktuator 24a weist den Trägerstreifen 32a auf, der über die Montageflansche 64a an seinen in Lateralerstreckungen liegenden Enden 72a am Rahmenabschnitt 22 fixiert ist. Die Aufteilung des Trägerstreifens 32a in die einzelnen Unterteilungsgruppen 38 bzw. die einzelnen Anbringungsabschnitte 40,44 und die Zwischenabschnitte 48,50 ist so, wie in Fig. 8 gezeigt, gewählt.

Im Unterschied zu dem Aktuator 24 der Fign. 8 bis 10 stützt sich der Aktuator 24a an dem Rahmenabschnitt 22 über insbesondere plattenförmige Verbindungselemente 54a ab. Diese Verbindungselemente 62a sind in den Zwischenabschnitten 48,50 angeordnet und stehen von dem Trägerstreifen 32a seitlich von dessen erster Außenfläche 42 ab. Sie erstrecken sich durch Aussparungen 80 in der Ausgleichsmasse 30a. Die Anbindung der Ausgleichsmasse 30a sowie des Bedienelements 14 jeweils an den Trägerstreifen 32a ist so realisiert, wie es weiter oben im Zusammenhang mit den Fign. 8 bis 10 beschrieben ist.

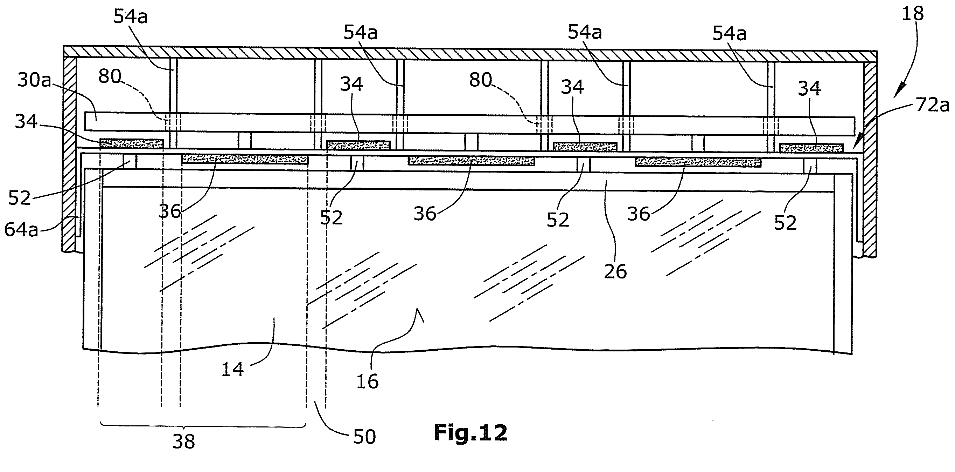

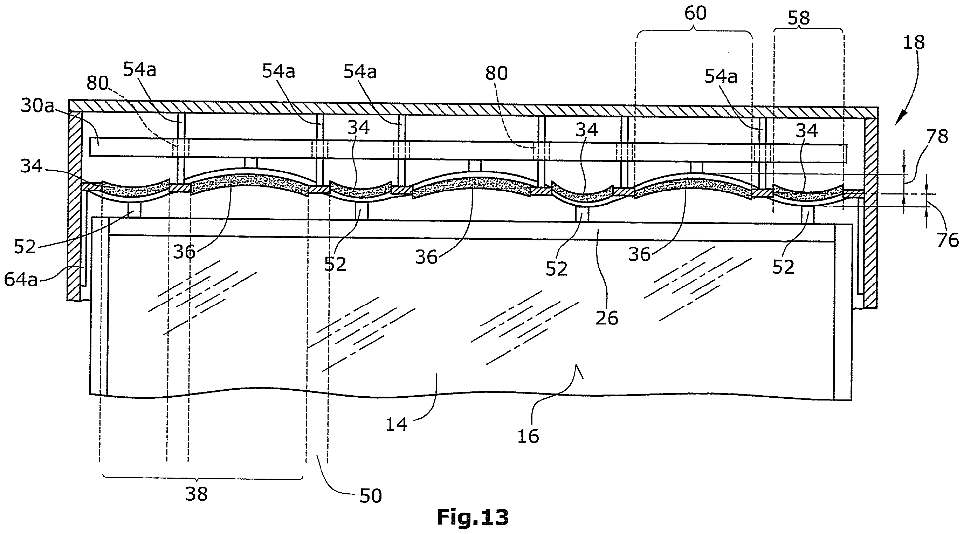

Die Situation im Ruhezustand sowie im aktivierten Zustand des Trägerstreifens 32a des Aktuators 24a ist in den Schnittansichten der Fign. 12 und 13 gezeigt.

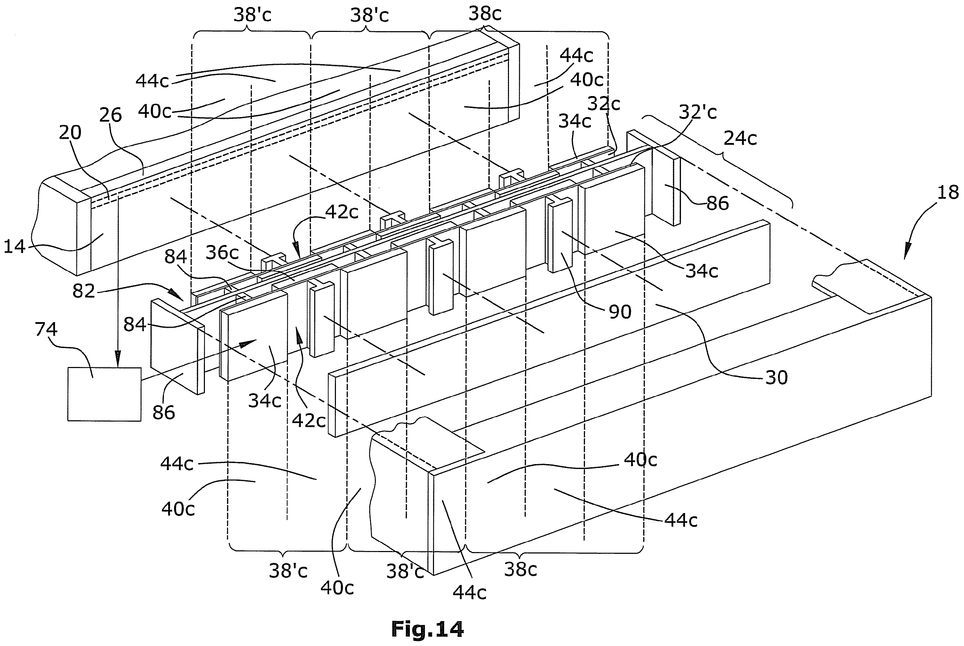

In den Fign. 14 bis 16 ist ein weiteres Ausführungsbeispiel eines Aktuators 24c gezeigt, der wiederum streifenförmig ausgebildet ist. Diejenigen Elemente des Aktuators 24c und der Bedieneinheit, die hinsichtlich ihrer Funktion bzw. Konstruktion den Elementen der Bedieneinheiten und Aktuatoren der Fign. 8 bis 13 gleichen bzw. entsprechen, sind in den Fign. 14 bis 16 mit den gleichen Bezugszeichen bzw. mit den gleichen Bezugszeichen, ergänzt um den Buchstaben c bezeichnet.

Der Aktuator 24c ist als Doppelstreifenaktuator ausgebildet und weist einen ersten Trägerstreifen 32c sowie einen zweiten Trägerstreifen 32'c auf. Beide Trägerstreifen 32c,32'c sind wechselweise mit ersten und zweiten Piezo-Elementen 34c bzw. 36c versehen. Diese Piezo-Elemente befinden sich wechselweise auf den ersten und zweiten Außenflächen 42c,46c der jeweiligen Trägerstreifen 32c,32'c. Beide Trägerstreifen sind jeweils unterteilt in eine erste Unterteilungsgruppe 38c sowie in zwei weitere zweite Unterteilungsgruppen 38'c. Die erste Unterteilungsgruppe 38c weist zwei erste Anbringungsabschnitte 40c und einen zweiten Anbringungsabschnitt 44c auf, der zwischen den beiden ersten Anbringungsabschnitten 40c der ersten Unterteilungsgruppe 38c positioniert ist. Jede weitere zweite Unterteilungsgruppe 38'c weist einen zweiten Anbringungsabschnitt 44c und einen ersten Anbringungsabschnitt 40c auf.

Zwischen den beiden Trägerstreifen 32c und 32'c verläuft ein Verbindungselement 82, das ebenfalls als Streifen ausgebildet ist und Verbindungsstege 84 zu den Trägerstreifen 32c und 32'c aufweist. Die Verbindungsstege 84 verbinden die beiden Trägerstreifen 32c,32'c miteinander, und zwar an den ersten Außenflächen 42c der Trägerstreifen in deren ersten Anbringungsabschnitten 40c. An den in Längserstreckung gegenüberliegenden Enden des Verbindungselements 82 ist dieses mit dem Rahmen 18 des Gehäuses 12 verbunden. Dies ist in den Fign. 14 bis 16 durch die Verbindungselemente 86 angedeutet.

Der erste Trägerstreifen 32c ist an seiner zweiten Außenfläche 46c innerhalb jedes zweiten Anbringungsabschnitts 44c über jeweils ein Verbindungselement 88 mit dem Bedienelement 14 mechanisch verbunden, während der zweite Trägerstreifen 32'c über Verbindungselemente 90, die an seiner zweiten Außenfläche 46c in jedem zweiten Anbringungsabschnitt 44c angeordnet sind, mit der Ausgleichsmasse 30 verbunden.

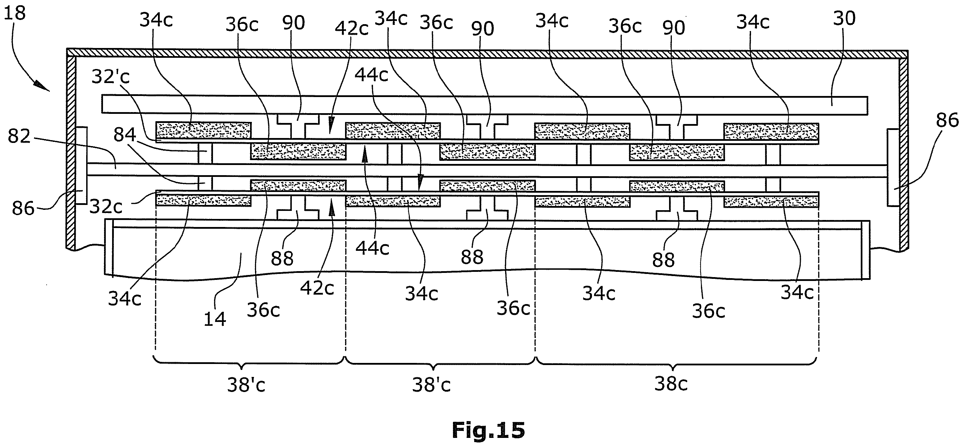

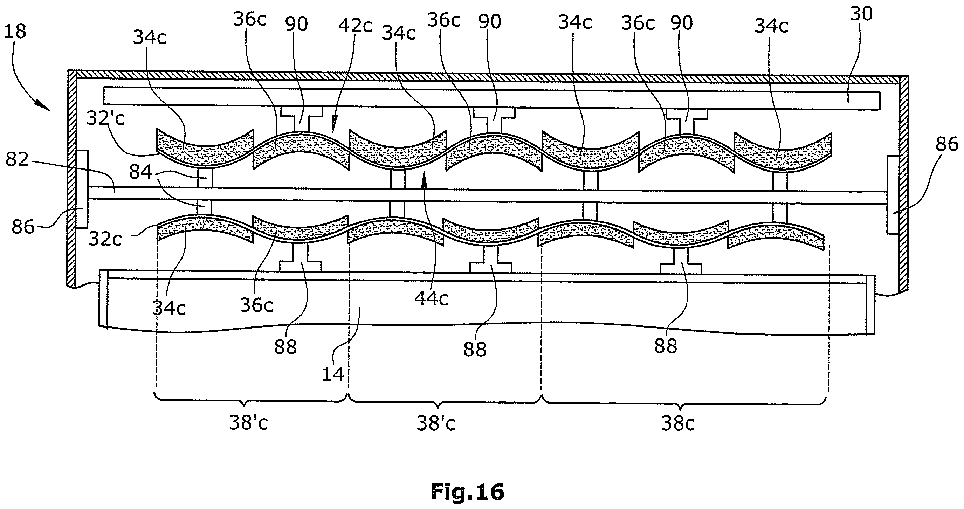

In den Fign. 14 und 15 ist der Aktuator 24c in seinem Ruhezustand gezeigt, in dem jeder der Trägerstreifen 32c,32'c einen in diesem Ausführungsbeispiel gradlinigen Verlauf aufweist. Bei Ansteuerung der Piezo-Elemente 34c,36c durch die Ansteuereinheit 74 verformen sich die Trägerstreifen 32c,32'c wellenförmig, wie es in Fig. 16 gezeigt ist. Bezogen auf das Verbindungselement werden also das Bedienelement 14 und die Ausgleichsmasse 30 gegensinnig abgestoßen, bewegen sich also voneinander weg, wobei durch entsprechende Wahl von Stärke und Größe der Piezo-Elemente 34c,36c des Trägerstreifens 32'c dessen Hub 78 größer gewählt sein sollte als der Hub 76, der durch den ersten Trägerstreifen 32c realisiert wird. Dementsprechend kann das Gewicht der Ausgleichsmasse 30 im Vergleich zum Gewicht des Bedienelements 14 kleiner gewählt werden, wobei es immer noch zu einem Impulsausgleich kommt.

Der Vollständigkeit halber sei an dieser Stelle erwähnt, dass das Konzept des Abstoßens von Bedienelement 14 und Ausgleichsmasse 30 des Aktuators 24c der Fign. 14 bis 16 auch invers gewählt werden kann. Die beiden Elemente Ausgleichsmasse 30 und Bedienelement 14 könnten also durch inverse Anordnung der Piezo-Elemente (bezogen auf die Außenflächen der beiden Trägerstreifen 32c,32'c) aufeinander zu bewegt werden, wenn der Aktuator 24c aktiviert ist. Auch dann käme es zu einer Impulskompensation.

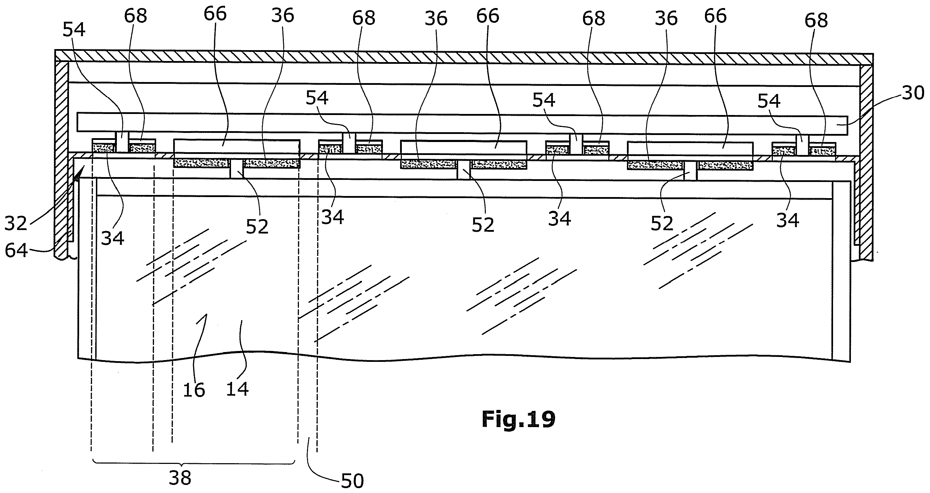

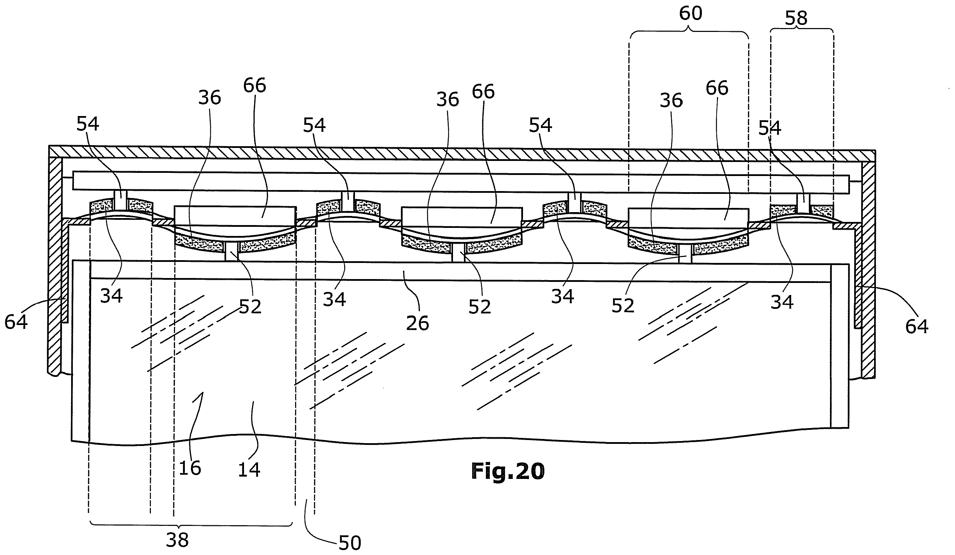

Anhand der Fign. 19 und 20 wird nachfolgend ein weiteres Ausführungsbeispiel eines erfindungsgemäßen Aktuators 24d beschrieben, bei dem es sich um eine Abwandlung des Aktuators 24 der Fign. 8 bis 10 handelt. Diejenigen Elemente des Aktuators 24d, die hinsichtlich ihrer Funktion bzw. Konstruktion ähnlich bzw. gleich denen des Aktuators 24 sind, sind in den Fign. 19 und 20 mit den gleichen Bezugszeichen wie in den Fign. 8 bis 10 versehen.

Der Unterschied des Aktuators 24d gegenüber dem Aktuator 24 ist darin zu sehen, dass innerhalb der einzelnen Anbringungsabschnitte 40,44 jeweils zwei erste bzw. zweite Piezo-Elemente 34 bzw. 36 angeordnet sind, wobei zwischen diesen jeweiligen Paaren von Piezo-Elementen die Verbindungselemente 52 zur mechanischen Verbindung mit dem Bedienelement 14 bzw. die Verbindungselemente 54 zur Verbindung des Trägerstreifens 32 mit der Ausgleichsmasse 30 angeordnet sind. Die Piezo-Elemente 34,36 (und die Verbindungselemente 52,54) sind jeweils an den Außenseiten der Halbwellenbögen des Trägerstreifens 32 angeordnet.

Die Erfindung wurde vorstehend von Ausführungsbeispielen beschrieben, bei denen wechselweise auf den beiden Außenseiten des Trägerstreifens Piezo-Elemente angeordnet sind, die sich bei elektrischer Ansteuerung sämtlich (auch) in Längserstreckung des Trägerstreifens ausdehnen oder zusammenziehen. Die Piezo-Elemente können aber auch auf beiden Außenseiten des Trägerstreifens angeordnet sein. Zur Erzielung der Wellenform sind dann die Piezo-Elemente auf der einen Außenseite derart anzuordnen, dass jedes zweite Piezo-Element sich ausdehnt und die dazwischen angeordneten Piezo-Elemente sich zusammenziehen, wobei die jeweils gegenüberliegenden Piezo-Elemente auf der anderen Außenseite des Trägerstreifens invers dazu sich verhalten, wenn sie angesteuert werden. Auch ist es möglich, die Piezo-Elemente auf lediglich einer gemeinsamen Außenseite des Trägerstreifens anzuordnen. Auch hier müsste die Ansteuerung der Piezo-Elemente dergestalt erfolgen, dass sich jedes zweite Piezo-Element ausdehnt und die dazwischenliegenden Piezo-Elemente sich zusammenziehen. Ferner kann der Trägerstreifen auch aus mehreren getrennten Teilträgerstreifenelementen bestehen, wobei jedes Teilträgerstreifenelement mindestens ein Piezo-Element auf mindestens einer Außenseite aufweist. Die zuvor beschriebenen Ausgestaltungen sowie die Ausgestaltungen gemäß den im Detail beschriebenen Ausführungsbeispielen der Erfindung können auch dergestalt erweitert werden, dass anstelle der einzelnen Piezo-Elemente jeweils Gruppen von dann gleich anzusteuernden Piezo-Elementen vorgesehen sind. Damit würden dann also mehrere Gruppen von Piezo-Elementen wechselweise auf unterschiedlichen Seiten oder auf einer Seite oder auch auf beiden Seiten angeordnet sein.

**BEZUGSZEICHENLISTE**

| | |
|---|---|
| 10' | Gehäuse |
| 12' | Bedienelement |
| 14' | Feder-Dämpfungssystem der elastischen Anbindung des Bedienelements am Gehäuse |
| 16' | Aktuator |
| 18' | Feder-Dämpfungssystem der (elastischen) Anbindung des Gehäuses ans Fahrzeug |
| 19' | Betätigungssensor |
| 20' | Ausgleichsmasse |
| 21' | Auswerte- und Ansteuereinheit |
| 22' | Feder-Dämpfungssystem der elastischen Anbindung der Ausgleichsmasse am Gehäuse und/oder am Bedienelements |
| 24' | Fahrzeug bzw. Instrumententafel des Fahrzeugs |
| 26' | Stator des als Aktuator ausgeführten Zugankerelektromagnets |
| 28' | Anker des Zugankerelektromagnets |
| 30' | Luftspalt des Zugankerelektromagnets |
| 32' | Bedienfeldführung für die Bewegung bei haptischer Rückmeldung |
| $m_1$ | Masse des Bedienfelds |
| $x_1(t)$ | Auslenkung des Bedienfelds |
| $F_{Akt}(t)$ | Aktuatorkraftverlauf |
| $F_1(t)$ | auf das Gehäuse 10' wirkende Kraft des Bedienfelds bei Anregung desselben ($F_1(t) = F_{Akt} - m_1 \times a_1$) |
| $c_1$ | Federkonstante der elastischen Anbindung des Bedienfelds am Gehäuse |
| $d_1$ | Dämpfung der elastischen Anbindung des Bedienfelds am Gehäuse |
| $m_2$ | Masse des Gehäuses |

| | |
|---|---|
| $x_2(t)$ | Auslenkung des Gehäuses in Folge der durch das mechanisch angeregte Bedienfeld ausgeübten Kraft |
| $F_2(t)$ | auf die Gehäusebefestigung wirkende Kraft |
| $m_3$ | Masse der Ausgleichsmasse |
| $x_3(t)$ | Auslenkung der Ausgleichsmasse |
| $F_3$ | durch die Ausgleichsmasse auf das Gehäuse wirkende Kraft |
| $c_3$ | Federkonstante der elastischen Anbindung der Ausgleichsmasse am Gehäuse |
| $d_3$ | Dämpfung der elastischen Anbindung der Ausgleichsmasse am Gehäuse |

| | |
|---|---|
| 10 | Bedieneinheit |
| 12 | Gehäuse |
| 14 | Bedienelement |
| 16 | Bedienoberfläche |
| 18 | Rahmen des Gehäuses |
| 20 | Betätigungssensor |
| 22 | Rahmenabschnitt |
| 24 | Aktuator |
| 24a | Aktuator |
| 24b | Aktuator |
| 24c | Aktuator |
| 24d | Aktuator |
| 26 | Randabschnitt |
| 28 | Trägerkörper |
| 30 | Ausgleichsmasse |
| 30a | Ausgleichsmasse |
| 32 | Trägerstreifen |
| 32a | Trägerstreifen |
| 32c | erster Trägerstreifen |
| 32'c | zweiter Trägerstreifen |
| 34 | erstes Piezo-Element |
| 34c | erstes Piezo-Element |
| 36 | zweites Piezo-Element |
| 36c | zweites Piezo-Element |
| 38 | Unterteilungsgruppen |
| 38c | erste Unterteilungsgruppe |
| 38'c | weitere Unterteilungsgruppe |
| 40 | erster Anbringungsabschnitt |
| 40c | erster Anbringungsabschnitt |
| 42 | erste Außenfläche |
| 42c | erste Außenfläche |
| 44 | zweiter Anbringungsabschnitt |
| 44c | zweiter Anbringungsabschnitt |
| 46 | zweite Außenfläche |
| 46c | zweite Außenfläche |
| 48 | erster Zwischenabschnitt |
| 50 | zweiter Zwischenabschnitt |
| 52 | Bedienelement-Verbindungselement |
| 54 | Ausgleichsmasse-Verbindungselement |
| 54a | plattenförmiges Verbindungselement |
| 56 | Wellenform |
| 58 | erste Halbwelle |
| 60 | zweite Halbwelle |
| 62 | erster Montageflansch |
| 62a | Verbindungselement |

| 64 | zweiter Montageflansch |
| 64a | zweiter Montageflansch |
| 66 | Aussparung |
| 68 | Aussparung |
| 70 | Steg |
| 72 | gegenüberliegenden Enden des Trägerstreifens |
| 72a | Ende des Trägerstreifens |
| 74 | Ansteuereinheit |
| 76 | Amplitude |
| 78 | Amplitude |
| 80 | Aussparung |
| 82 | Verbindungselement |
| 84 | Verbindungssteg |
| 86 | Verbindungselement |
| 88 | Verbindungselement |
| 90 | Verbindungselement |

**Patentansprüche**

1.  Bedieneinheit für ein Gerät, z.B. für eine Fahrzeugkomponente, insbesondere Mensch-Maschine-Interface (MMI bzw. HMI), mit

    - einem Gehäuse (12), das ein Bedienelement (14) mit einem Bedienfeld (16), wie z.B. ein Touchscreen oder ein Touchpad oder ein Display oder eine Abdeckscheibe eines Touchscreen oder eines Displays aufweist und zur Befestigung in/an einem Gerät, insbesondere an einer Fahrzeug-Instrumententafel oder Fahrzeug-Mittelkonsole vorgesehen ist,
    - wobei das Bedienelement (14) elastisch in dem Gehäuse (12) gelagert ist,
    - einem Sensor (20) zur Erkennung einer Bedienung des Bedienelements (14),
    - einem Aktuator (24,24a,24b,24d) zur bei Erkennung einer Bedienung des Bedienelements (14) erfolgenden mechanischen Anregung des Bedienelements (14) und
    - einer Ausgleichsmasse (30,30a), die beweglich in/an dem Gehäuse (12) gelagert ist,
    - wobei die Ausgleichsmasse (30,30a) bei Erkennung einer Bedienung des Bedienelements (14) von dem oder von einem Aktuator (24,24a,24b,24d) mechanisch anregbar ist und
    - wobei die Ausgleichsmasse (30,30a) zur im Wesentlichen Kompensation und/oder Verhinderung und/oder Dämpfung von Kräften bewegbar ist, die infolge der bei Aktivierung des Aktuators (24,24a,24b,24d) erfolgenden Bewegung des Bedienelements (14) auf das Gehäuse (12) wirken,
    dadurchge kennzeichnet,
    - dass der Aktuator (24,24a,24b,24d) versehen ist mit
    - einem ein federelastisches Material, insbesondere Federstahl a aufweisenden Trägerstreifen (32,32a) mit einer ersten Außenfläche (42) und einer zweiten Außenfläche (44),
- wobei der Trägerstreifen (32,32a) mindestens eine Unterteilungsgruppe (38) aus einem ersten Anbringungsabschnitt (40), einem zweiten Anbringungsabschnitt (44) und einem zwischen den beiden Anbringungsabschnitten (40,44) angeordneten ersten Zwischenabschnitt (48) aufweist, wobei der erste Anbringungsabschnitt (40), der erste Zwischenabschnitt (48) und der zweite Anbringungsabschnitt (44) in Längserstreckung des Trägerstreifens (32,32a) aufeinanderfolgend angeordnet sind,
- wobei der Trägerstreifen (32,32a) bei mehreren in seiner Längserstreckung benachbarten Unterteilungsgruppen (38) zwischen dem zweiten Anbringungsabschnitt (44) der einen Unterteilungsgruppe (38) und dem ersten Anbringungsabschnitt (40) der benachbarten Unterteilungsgruppe (38) einen zweiten Zwischenabschnitt (50) aufweist,
- ersten und zweiten schubsteif mit dem Trägerstreifen (32,32a) verbundenen, elektrisch ansteuerbaren Piezo-Elementen (34,36), von denen jedes - in Längserstreckung des Trägerstreifens (32,32a) betrachtet - eine Länge aufweist, die ohne elektrische Ansteuerung des Piezo-Elements (34,36) einen ersten Längenwert und bei elektrischer Ansteuerung einen vom ersten Längenwert verschiedenen zweiten Längenwert annimmt,
- wobei mindestens ein erstes Piezo-Element (34) in einem ersten Anbringungsabschnitt (40) des Trägerstreifens (32,32a) an dessen ersten Außenfläche (42) und mindestens ein zweites Piezo-Element (36) in einem zweiten Anbringungsabschnitt (44) des Trägerstreifens (32,32a) an dessen zweiten Außenfläche (46) angeordnet ist,
- wobei die ersten Zwischenabschnitte (48) und, sofern vorhanden, die zweiten Zwischenabschnitte (50) des Trägerstreifens (32,32a) zwecks Fixierung des Trägerstreifens (32,32a) mit dem Gehäuse (12) mechanisch gekoppelt sind und
- wobei der Trägerstreifen(32,32a) in einem ersten Anbringungsabschnitt (40) mechanisch mit dem Bedienelement (14) und in einem zweiten Anbringungsabschnitt (44) mechanisch mit der Ausgleichsmasse (30) gekoppelt ist und
- dass eine Ansteuereinheit (74) vorgesehen ist, mittels derer die Piezo-Elemente (34,36) zur Überführung des Trägerstreifens (32,32a) aus dessen Ruhezustand, in dem das Bedienelement (14) und die Ausgleichsmasse (30), die beidseitig des Trägerstreifens (32,32a) angeordnet sind, einen ersten Abstand voneinander aufweisen, unter Verschiebung von Bedienelement (14) und Ausgleichsmasse (30) in entgegengesetzten Richtungen in einen wellenförmigen Aktivierungszustand und zum Überführen des Trägerstreifens (32,32a) aus dem Aktivierungszustand zurück in den Ruhezustand ansteuerbar sind.

2. Bedieneinheit nach Anspruch 1, **dadurch gekennzeichnet, dass** der Trägerstreifen (32,32a) in seinem Ruhezustand längs einer Referenzlinie verläuft und dass die Wellenform (56) des Trägerstreifens (32,32a) in seinem Aktivierungszustand erste Halbwellen (58) zu einer Seite der Referenzlinie und zweite Halbwellen (60) zu der gegenüberliegenden Seite der Referenzlinie aufweist, wobei jeder erste Anbringungsabschnitt (40) des Trägerstreifens (32,32a) eine erste Halbwelle (58) mit der Referenzlinie zugewandtem - oder alternativ abgewandtem - ersten Piezo-Element (34) sowie der Referenzlinie abgewandter - oder alternativ zugewandter - zweiten Außenfläche (46) und jeder zweite Anbringungsabschnitt (44) des Trägerstreifens (32,32a) eine zweite Halbwelle (60) mit der Referenzlinie zugewandtem - oder alternativ abgewandtem - zweiten Piezo-Element (36) sowie der Referenzlinie zugewandter erster - oder alternativ abgewandter - zweiten Außenfläche (46) bildet.

3. Bedieneinheit nach Anspruch 1 oder 2, **dadurch gekennzeichnet, dass** der Trägerstreifen (32,32a) an seinen in Längserstreckung gegenüberliegenden Enden (70,72,72a) mit jeweils einem zweiten Zwischenabschnitt (50) versehen ist, neben dem ein erster Anbringungsabschnitt (40) angeordnet ist, der seinerseits gegenüber einem benachbarten zweiten Anbringungsabschnitt (44) um einen ersten bzw. zweiten Zwischenabschnitt (48,50) beabstandet ist.

4. Bedieneinheit nach einem der Ansprüche 1 bis 3, **dadurch gekennzeichnet, dass** der Trägerstreifen (32,32a) an seinen Lateralrändern mit jeweils einem ersten Montageflansch (62) zur Befestigung am Gehäuse (12) versehen ist, dass die Montageflansche (62) durch Stege (70) mit den ersten und, sofern vorhanden, zweiten Zwischenabschnitten (48,50) verbunden sind, und dass in dem Trägerstreifen (32,32a) und/oder in den Montageflanschen (62) zwischen den Stegen (70) angeordnete, an die Lateralränder des Trägerstreifens (32,32a) angrenzende Aussparungen (66,68) ausgebildet sind.

5. Bedieneinheit nach Anspruch 4, **dadurch gekennzeichnet, dass** die ersten Montageflansche (62) bezogen auf den Trägerstreifen (32,32a) zu dessen Seite abgewinkelt, insbesondere zu dessen Seite rechtwinklig abgewinkelt verlaufen.

6. Bedieneinheit nach einem der Ansprüche 1 bis 5, **dadurch gekennzeichnet, dass** der Trägerstreifen (32,32a) an seinen in Längserstreckung gegenüberliegenden Enden (72) mit jeweils einem zweiten Montageflansch (64,64a) zur Befestigung an dem Gehäuse (12) versehen ist.

7. Bedieneinheit nach Anspruch 6, **dadurch gekennzeichnet, dass** die zweiten Montageflansche (64,64a) bezogen auf den Trägerstreifen (32,32a) zu dessen Seite abgewinkelt, insbesondere zu dessen Seite rechtwinklig abgewinkelt verlaufen.

8. Bedieneinheit nach einem der Ansprüche 1 bis 3, **dadurch gekennzeichnet, dass** von dem Trägerstreifen (32,32a) innerhalb der ersten und, sofern vorhanden, zweiten Zwischenabschnitte (48,50) Verbindungselemente (62a) zur Fixierung des Trägerstreifens (32,32a) in/an dem Gehäuse (12) abstehen.

9. Bedieneinheit nach Anspruch 8, **dadurch gekennzeichnet, dass** die Ausgleichsmasse (30a) als ein Materialstreifenkörper ausgebildet ist, der Aussparungen (80) aufweist, durch die hindurch sich die Verbindungselemente (62) mit Spiel erstrecken.

10. Bedieneinheit nach einem der Ansprüche 1 bis 9, **dadurch gekennzeichnet, dass** im Aktivierungszustand des Trägerstreifens (32,32a) das Verhältnis aus der Amplitude (76) der ersten Halbwelle (58) zu der Amplitude (78) der zweiten Halbwelle (60) invers zum Verhältnis des Gewichts des Bedienelements (14) zum Gewicht der Ausgleichsmasse (30,30a) ist.

11. Bedieneinheit nach einem der Ansprüche 1 bis 10, **dadurch gekennzeichnet, dass** die Ausgleichsmasse (30,30a) als ein Materialstreifen ausgebildet ist.

12. Bedieneinheit nach einem der Ansprüche 1 bis 11, **dadurch gekennzeichnet, dass** der Aktuator (24,24a,24b,24d) längs eines ersten Randabschnitts (26) des Bedienelements (14) angeordnet ist.

13. Bedieneinheit für ein Gerät, z.B. für eine Fahrzeugkomponente, insbesondere Mensch-Maschine-Interface (MMI bzw. HMI),

    - einem Gehäuse (12), das ein Bedienelement (14) mit einem Bedienfeld (16), wie z.B. ein Touchscreen oder ein Touchpad oder ein Display oder eine Abdeckscheibe eines Touchscreen oder eines Displays aufweist und zur Befestigung in/an einem Gerät, insbesondere an einer Fahrzeug-Instrumententafel oder Fahrzeug-Mittelkonsole vorgesehen ist,
    - wobei das Bedienelement (14) elastisch in dem Gehäuse (12) gelagert ist,
- einem Sensor (20) zur Erkennung einer Bedienung des Bedienelements (14),
- einem Aktuator (24c) zur bei Erkennung einer Bedienung des Bedienelements (14) erfolgenden mechanischen Anregung des Bedienelements (14) und
- einer Ausgleichsmasse (30), die beweglich in/an dem Gehäuse (12) gelagert ist,
- wobei die Ausgleichsmasse (30) bei Erkennung einer Bedienung des Bedienelements (14) von dem oder von einem Aktuator (24c) mechanisch anregbar ist und
- wobei die Ausgleichsmasse (30) zur im Wesentlichen Kompensation und/oder Verhinderung und/oder Dämpfung von Kräften bewegbar ist, die infolge der bei Aktivierung des Aktuators (24c) erfolgenden Bewegung des Bedienelements (14) auf das Gehäuse (12) wirken, **dadurch gekennzeichnet,**
- **dass** der Aktuator (24c) versehen ist mit
- einem ein federelastisches Material, insbesondere Federstahl a, aufweisenden ersten Trägerstreifen (32c) mit einer ersten Außenfläche (42c) und einer zweiten Außenfläche (46c),
- wobei der erste Trägerstreifen (32c) mindestens eine Unterteilungsgruppe (38c) mit zwei ersten Anbringungsabschnitten (40c) und jeweils einem zwischen diesen angeordneten zweiten Anbringungsabschnitt (44c) aufweist, wobei die Anbringungsabschnitte (40c,44c) in Längserstreckung des ersten Trägerstreifens (32c) aufeinanderfolgend angeordnet sind,
- einem parallel zum ersten Trägerstreifen (32c) verlaufenden, ein federelastisches Material, insbesondere Federstahl a, aufweisenden zweiten Trägerstreifen (32'c) mit einer der ersten Außenfläche (42c) des ersten Trägerstreifen (32c) zugewandten ersten Außenfläche (32c) und einer der ersten Außenfläche (42c) des ersten Trägerstreifens (32c) abgewandten zweiten Außenfläche (46c),
- wobei der zweite Trägersteifen (32'c) mindesten eine Unterteilungsgruppe (38c) mit zwei ersten Anbringungsabschnitten (40c) und einem zwischen diesen angeordneten zweiten Anbringungsabschnitt (44c) aufweist, wobei die Anbringungsabschnitte (40c,44c) in Längserstreckung des zweiten Trägerstreifens (32c) aufeinanderfolgend angeordnet sind,
- einem Verbindungselement (82), mittels dessen die beiden Trägerstreifen (32c,32'c) untereinander verbunden sind und das zur Fixierung der beiden Trägerstreifen (32c,32'c) mit dem Gehäuse (12) verbunden ist, wobei das Verbindungselement (82) erste Anbringungsabschnitte (40c) des ersten Trägerstreifens (32c) an dessen ersten Außenfläche (32c) mit ersten Anbringungsabschnitten (40c) des zweiten Trägerstreifens (32'c) an dessen ersten Außenfläche (42c) verbindet,
- ersten und zweiten schubsteif mit den beiden Trägerstreifen (32c,32'c) verbindenden, elektrisch ansteuerbaren Piezo-Elementen (34c,36c), von denen jedes - in Längserstreckung des Trägerstreifens (32c,32'c) betrachtet - eine Länge aufweist, die ohne elektrische Ansteuerung des Piezo-Elements (34c,36c) einen ersten Längenwert und bei elektrischer Ansteuerung einen vom ersten Längenwert verschiedenen zweiten Längenwert annimmt,
- wobei in jedem ersten Anbringungsabschnitt (40c) des ersten Trägerstreifens (32c) an dessen zweiten Außenfläche (46c) mindestens ein erstes Piezo-Element (34c) angeordnet ist sowie in jedem zweiten Anbringungsabschnitt (44c) des ersten Trägerstreifens (32c) an dessen ersten Außenfläche (42c) mindestens ein zweites Piezo-Element (36c) angeordnet ist und wobei in jedem ersten Anbringungsabschnitt (40c) des zweiten Trägerstreifens (32'c) an dessen zweiten Außenfläche (46c) mindestens ein erstes Piezo-Element (34c) sowie in jedem zweiten Anbringungsabschnitt (44c) des zweiten Trägerstreifens (32'c) an dessen ersten Außenfläche (42c) mindestens ein zweites Piezo-Element (36c) angeordnet ist und
- wobei der erste Trägerstreifen (32c) in jedem zweiten Anbringungsabschnitt (44c) mechanisch mit dem Bedienelement (14) und der zweite Trägerstreifen (32'c) in jedem zweiten Anbringungsabschnitt (44c) mechanisch mit der Ausgleichsmasse (30c) gekoppelt ist, und
- **dass** eine Ansteuereinheit (74) vorgesehen ist, mittels derer die Piezo-Elemente (34c,36c) zur Überführung beider Trägerstreifen (32c,32'c) aus deren jeweiligen Ruhezustand, in dem das Bedienelement (14) und die Ausgleichsmasse (30c), die sich beidseitig der Anordnung aus den beiden Trägerstreifen (32c,32'c) und dem Verbindungselement (82) befinden, einen ersten Abstand voneinander aufweisen, unter Verschiebung von Bedienelement (14) und Ausgleichsmasse (30c) in entgegengesetzten Richtungen in einen wellenförmigen Aktivierungszustand, in dem Bedienelement (14) und Ausgleichsmasse (30c) einen vom ersten Abstand verschiedenen zweiten Abstand voneinander aufweisen, und zum Überführen der Trägerstreifen (32c,32'c) aus deren jeweiligem Aktivierungszustand zurück in deren jeweiligen Ruhezustand ansteuerbar sind.

14. Bedieneinheit nach Anspruch 13, **dadurch gekennzeichnet, dass** die beiden Trägerstreifen (32c,32'c) in ihrem jeweiligen Ruhezustand jeweils längs einer Referenzlinie verlaufen und dass die Wellenform (56) der beiden Trägerstreifen (32c,32'c) in deren jeweiligem Aktivierungszustand erste Halbwellen (58) zu einer Seite der jeweiligen Referenzlinie und zweite Halbwellen (60) zu der gegenüberliegende Seite der jeweiligen Referenzlinie aufweisen, wobei jeder erste Anbringungsabschnitt (40c) des ersten Trägerstreifens (32c) eine erste Halbwelle (58) mit der Referenzlinie des ersten Trägerstreifens (32c) zugewandtem - oder alternativ abgewandtem - ersten Piezo-Element (34c) und der Referenzlinie des ersten Trägerstreifens (32c) abgewandter - oder alternativ zugewandter - erster Außenfläche (42c) sowie jeder zweite Anbringungsabschnitt (44c) des ersten Trägerstreifens (32c) eine zweite Halbwelle (60) mit der Referenzlinie des ersten Trägerstreifens (32c) zugewandtem - oder alternativ abgewandtem - zweiten Piezo-Element (36c) und der Referenzlinie des ersten Trägerstreifens (32c) abgewandter - oder alternativ zugewandter - erster Außenfläche (42c) bildet und wobei jeder erste Anbringungsabschnitt (40c) des zweiten Trägerstreifens (32'c) eine erste Halbwelle (58) mit der Referenzlinie des zweiten Trägerstreifens (32'c) zugewandtem - oder alternativ abgewandtem - ersten Piezo-Element (34c) und der Referenzlinie des zweiten Trägerstreifens (32'c) abgewandter - oder alternativ zugewandter - erste Außenfläche (42c) sowie jeder zweite Anbringungsabschnitt (44c) des zweiten Trägerstreifens (32'c) eine zweite Halbwelle (60) mit der Referenzlinie des zweiten Trägerstreifens (32'c) zugewandtem - oder alternativ abgewandtem - zweiten Piezo-Element (36c) und der Referenzlinie des zweiten Trägerstreifens (32'c) abgewandter - oder alternativ zugewandter - zweiter Außenfläche (46c) bildet.

15. Bedieneinheit nach Anspruch 13 oder 14, **dadurch gekennzeichnet, dass** das Verbindungselement (82) in dem Zwischenraum zwischen den beiden Trägerstreifen (32c,32'c) angeordnet ist und außerhalb des von den Trägerstreifen (32c,32'c) eingenommenen Bereichs mit dem Gehäuse (12) verbunden ist.

16. Bedieneinheit nach einem der Ansprüche 13 bis 15, **dadurch gekennzeichnet, dass** im Aktivierungszustand beider Trägerstreifen (32c,32'c) das Verhältnis aus der Summe der Amplituden (76,78) der ersten und zweiten Halbwellen (58,60) des ersten Trägerstreifens (32c) zu der Summe der Amplituden (76,78) der ersten und zweiten Halbwellen (58,60) des zweiten Trägerstreifens (32c,32'c) invers zum Verhältnis des Gewichts des Bedienelements (14) zu dem Gewicht der Ausgleichsmasse (30c) ist.

17. Bedieneinheit nach einem der Ansprüche 13 bis 16, **dadurch gekennzeichnet, dass** der Aktuator (24c) längs eines ersten Randabschnitts (26) des Bedienelements (14) angeordnet ist.

18. Bedieneinheit nach einem der Ansprüche 13 bis 17, **dadurch gekennzeichnet,**

- **dass** jeder Trägerstreifen (32c,32'c) mindestens eine weitere Unterteilungsgruppe (38c,38'c) aufweist, die einen ersten Anbringungsabschnitt (40c) und einen zweiten Anbringungsabschnitt (44c) aufweist, der neben einem ersten Anbringungsabschnitt (40c) einer benachbarten Unterteilungsgruppe (38c) angeordnet ist,
- **dass** das Verbindungselement (82) die beiden Trägerstreifen (32c,32'c) in dem ersten Anbringungsabschnitt (40c) jeder weiteren Unterteilungsgruppe (38'c) verbindet,
- **dass** das Bedienelement (14) mit dem ersten Trägerstreifen (32c) an dessen zweiter Außenfläche (46c) in den zweiten Anbringungsabschnitt (44c) jeder weiteren Unterteilungsgruppe (38'c) und die Ausgleichsmasse (30c) mit dem zweiten Trägerstreifen (32'c) an dessen zweiter Außenfläche (46c) in den ersten Anbringungsabschnitt (40c) jeder weiteren Unterteilungsgruppe (38'c) mechanisch gekoppelt ist und
- **dass** an der zweiten Außenfläche (46c) jedes Trägerstreifens (32c,32'c) in dem ersten Anbringungsabschnitt (40c) jeder weiteren Unterteilungsgruppe (38'c) ein erstes Piezo-Element (34c) und an der ersten Außenfläche (42c) jedes Trägerstreifens (32c,32'c) in den zweiten Anbringungsabschnitt (44c) jeder weiteren Unterteilungsgruppe (38'c) ein zweites Piezo-Element (36c) schubsteif mit dem betreffenden Trägerstreifen (32c,32'c) verbunden ist.

19. Bedieneinheit nach einem der Ansprüche 1 bis 18, **dadurch gekennzeichnet, dass** der Aktuator (24) als ein Piezo-Aktuator ausgebildet ist und ein elektrisch anregbares Piezokeramikelement sowie ein mechanisches Getriebe zum Umsetzen einer Längenausdehnung mit anschließender Längenverkürzung des Piezokeramikelements in eine Bewegung des Bedienelements (14) aufweist, wobei das mechanische Getriebe mindestens ein die Ausgleichsmasse (30) und/oder ein Teil der Ausgleichsmasse (30) und/oder die elastische Lagerung des Bedienelements (14) bildendes Getriebeelement und mindestens ein die elastische Lagerung des Bedienelements (14) bildendes weiteres Getriebeelement aufweist.

**Claims**

1. An operating unit for a device, for example for a vehicle component, in particular human-machine interface (MMI or HMI), comprising

- a housing (12) having an operating element (14) with an operating field (16), such as a touchscreen, or a touchpad, or a display, or a cover plate of a touchscreen or a display, and provided to be fastened in and/or to a device, in particular to a vehicle dashboard or vehicle center console,
- wherein the operating element (14) is mounted elastically in the housing (12),
- a sensor (20) for identifying operation of the operating element (14),
- an actuator (24, 24a, 24b, 24d) for mechanically exciting the operating element (14) in the event that operation of the operating element (14) has been identified, and
- a counterbalance (30, 30a), which is mounted movably in/on the housing (12),
- wherein the counterbalance (30, 30a) is mechanically excitable by the or an actuator (24, 24a, 24b, 24d) in the event that operation of the operating element (14) has been identified,
- wherein the counterbalance (30, 30a) is movable for substantial compensation and/or prevention and/or damping of forces that act on the housing (12) as a result of the movement of the operating element (14) occurring when the actuator (24, 24a, 24b, 24d) is activated, **characterized in that**
- the actuator (24, 24a, 24b, 24d) is provided with

    - a support strip (32, 32a) comprising a resilient material, in particular spring steel, and having a first outer surface (42) and a second outer surface (44),
    - wherein the support strip (32, 32a) has at least one dividing group (38) formed of a first attachment portion (40), a second attachment portion (44) and a first intermediate portion (48) arranged between the two attachment portions (40, 44), wherein the first attachment portion (40), the first intermediate portion (48) and the second attachment portion (44) are arranged in succession in the longitudinal extent of the support strip (32, 32a),
    - wherein, with a plurality of adjacent dividing groups (38) in its longitudinal extent, the support strip (32, 32a) has a second intermediate portion (50) between the second attachment portion (44) of one dividing group (38) and the first attachment portion (40) of the adjacent dividing group (38),
    - first and second electrically controllable piezo elements (34, 36) connected in a shear-resistant manner to the support strip (32, 32a), each of which piezo elements - considered in the longitudinal extent of the support strip (32, 32a) - has a length that without electrical actuation of the piezo element (34, 36) assumes a first length value and with electrical actuation assumes a second length value, which is different from the first length value,
- wherein at least one first piezo element (34) is arranged in a first attachment portion (40) of the support strip (32, 32a) on the first outer surface (42) thereof and at least one second piezo element (36) is arranged in a second attachment portion (44) of the support strip (32, 32a) on the second outer surface (46) thereof,
- wherein the first intermediate portions (48) and, if provided, the second intermediate portions (50) of the support strip (32, 32a) are mechanically coupled to the housing (12) for the purpose of fixing the support strip (32, 32a), and
- wherein the support strip (32, 32a) is mechanically coupled to the operating element (14) in a first attachment portion (40) and is mechanically coupled to the counterbalance (30) in a second attachment portion (44), and
- a control unit (74), by means of which the piezo elements (34, 36) can be actuated in order to transfer the support strip (32, 32a) from its inactivated state, in which the operating element (14) and the counterbalance (30), which are arranged on either side of the support strip (32, 32a), have a first distance from one another, with displacement of operating element (14) and counterbalance (30) in opposite directions, into an undulating activated state, and in order to transfer the support strip (32, 32a) from the activated stated back into the inactivated state.

2. The operating unit according to claim 1, **characterized in that** the support strip (32, 32a), in its inactivated state, runs along a reference line, and **in that** the undulating form (56) of the support strip (32, 32a), in the activated state of said support strip, has first half waves (58) on one side of the reference line and second half waves (60) on the opposite side of the reference line, wherein each first attachment portion (40) of the support strip (32, 32a) has a first half wave (58) with first piezo element (34) facing - or alternatively facing away from - the reference line and second outer surface (46) facing away from - or alternatively facing - the reference line, and each second attachment portion (44) of the support strip (32, 32a) forms a second half wave (60) with second piezo element (36) facing - or alternatively facing away from - the reference line and first second outer surface (46) facing - or alternatively facing away from - the reference line.

3. The operating unit according to claim 1 or 2, **characterized in that** the support strip (32, 32a) is provided at each of its opposite ends (70, 72, 72a) in the longitudinal extent with a second intermediate portion (50), next to which there is arranged a first attachment portion (40), which is in turn distanced from an adjacent second attachment portion (44) by a first or second intermediate portion (48, 50).

4. The operating unit according to any one of claims 1 to 3, **characterized in that** the support strip (32, 32a) is provided at each of its lateral edges with a first mounting flange (62) for fastening to the housing (12), **in that** the mounting flanges (62) are connected by bridges (70) to the first and, if provided, second intermediate portions (48, 50), and **in that** recesses (66, 68) arranged between the bridges (70) and adjacent to the lateral edges of the support strip (32, 32a) are formed in the support strip (32, 32a) and/or in the mounting flanges (62).

5. The operating unit according to claim 4, **characterized in that** the first mounting flanges (62), in relation to the support strip (32, 32a), run at an angle to the side thereof, in particular at right angles to the side thereof.

6. The operating unit according to any one of claims 1 to 5, **characterized in that** the support strip (32, 32a) is provided at each of its opposite ends (72) in longitudinal extent with a second mounting flange (64, 64a) for fastening to the housing (12).

7. The operating unit according to claim 6, **characterized in that** the second mounting flanges (64, 64a), in relation to the support strip (32, 32a), run at an angle to the side thereof, in particular at right angles to the side thereof.

8. The operating unit according to any one of claims 1 to 3, **characterized in that** connection elements (62a) for fixing the support strip (32, 32a) in/on the housing (12) protrude from the support strip (32, 32a) within the first and, if provided, second intermediate portions (48, 50).

9. The operating unit according to claim 8, **characterized in that** the counterbalance (30a) is formed as a material strip body, which has recesses (80), through which the connection elements (62) extend with play.

10. The operating unit according to any one of claims 1 to 9, **characterized in that**, in the activated state of the support strip (32, 32a), the ratio of the amplitude (76) of the first half wave (58) to the amplitude (78) of the second half wave (60) is inverse to the ratio of the weight of the operating element (14) to the weight of the counterbalance (30, 30a).

11. The operating unit according to any one of claims 1 to 10, **characterized in that** the counterbalance (30, 30a) is formed as a material strip.

12. The operating unit according to any one of claims 1 to 11, **characterized in that** the actuator (24, 24a, 24b, 24d) is arranged along a first edge portion (26) of the operating element (14).

13. The operating unit for a device, for example for a vehicle component, in particular human-machine interface (MMI or HMI), comprising

   - a housing (12) having an operating element (14) with an operating field (16), such as a touchscreen, or a touchpad, or a display, or a cover plate of a touchscreen or a display, and provided to be fastened in and/or to a device, in particular to a vehicle dashboard or vehicle center console,
   - wherein the operating element (14) is mounted elastically in the housing (12),
   - a sensor (20) for identifying operation of the operating element (14),
   - an actuator (24c) for mechanically exciting the operating element (14) in the event that operation of the operating element (14) has been identified, and
   - a counterbalance (30), which is mounted movably in/on the housing (12),
   - wherein the counterbalance (30) is mechanically excitable by the or an actuator (24c) in the event that operation of the operating element (14) has been identified,
   - wherein the counterbalance (30) is movable for substantial compensation and/or prevention and/or damping of forces that act on the housing (12) as a result of the movement of the operating element (14) occurring when the actuator (24c) is activated,
   **characterized in that**
   - the actuator (24c) is provided with

      - a first support strip (32c) comprising a resilient material, in particular spring steel, and having a first outer surface (42c) and a second outer surface (46c),
      - wherein the first support strip (32c) has at least one dividing group (38c) with two first attachment portions (40c) and a second attachment portion (44c) arranged in each case therebetween, wherein the attachment portions (40c, 44c) are arranged in succession in the longitudinal extent of the first support strip (32c),

- a second support strip (32'c), running parallel to the first support strip (32c), comprising a resilient material, in particular spring steel, and having a first outer surface (32c) facing the first outer surface (42c) of the first support strip (32c) and a second outer surface (46c) facing away from the first outer surface (42c) of the first support strip (32c),

- wherein the second support strip (32'c) comprises at least one dividing group (38c) with two first attachment portions (40c) and a second attachment portion (44c) arranged therebetween, wherein the attachment portions (40c, 44c) are arranged in succession in the longitudinal extent of the second support strip (32c),

- a connection element (82), by means of which the two support strips (32c, 32'c) are connected to one another and which is connected to the housing (12) in order to fix the two support strips (32c, 32'c), wherein the connection element (82) connects first attachment portions (40c) of the first support strip (32c) on the first outer surface (32c) thereof to first attachment portions (40c) of the second support strip (32'c) on the first outer surface (42c) thereof,

- first and second electrically actuatable piezo elements (34c, 36c) connected in a shear-resistant manner to the two support strips (32c, 32'c), each of which piezo elements - considered in the longitudinal extent of the support strip (32c, 32'c) - has a length that without electrical actuation of the piezo element (34c, 36c) assumes a first length value and with electrical actuation assumes a second length value different from the first length value,

- wherein at least one first piezo element (34c) is arranged in each first attachment portion (40c) of the first support strip (32c) on the second outer surface (46c) thereof and at least one second piezo element (36c) is arranged in each second attachment portion (44c) of the first support strip (32c) on the first outer surface (42c) thereof, and wherein at least one first piezo element (34c) is arranged in each first attachment portion (40c) of the second support strip (32'c) on the second outer surface (46c) thereof, and at least one second piezo element (36c) is arranged in each second attachment portion (44c) of the second support strip (32'c) on the first outer surface (42c) thereof, and

- wherein the first support strip (32c) is coupled mechanically in each second attachment portion (44c) to the operating element (14), and the second support strip (32'c) is coupled mechanically in each second attachment portion (44c) to the counterbalance (30),

- **in that** a control unit (74) is provided, by means of which the piezo elements (34c, 36c) can be actuated in order to transfer both support strips (32c, 32'c) from their inactivated states, in which the operating element (14) and the counterbalance (30c), which are arranged on either side of the arrangement formed of the two support strips (32c, 32'c) and the connection element (82), have a first distance from one another, with displacement of operating element (14) and counterbalance (30c) in opposite directions, into an undulating activated state, in which the operating element (14) and counterbalance (30c) have a second distance from one another, different from the first distance, and in order to transfer the support strips (32c, 32'c) from their activated states back into their inactivated states.

14. The operating unit according to claim 13, **characterized in that** the two support strips (32c, 32'c) in their inactivated states each run along a reference line, and **in that** the undulating forms (56) of the two support strips (32c, 32'c) in their activated states have first half waves (58) on one side of the relevant reference line and second half waves (60) on the opposite side of the relevant reference line, wherein each first attachment portion (40c) of the first support strip (32c) forms a first half wave (58) with first piezo element (34c) facing - or alternatively facing away from - the reference line of the first support strip (32c) and first outer surface (42c) facing away from - or alternatively facing - the reference line of the first support strip (32c), and each second attachment portion (44c) of the first support strip (32c) forms a second half wave (60) with second piezo element (36c) facing - or alternatively facing away from - the reference line of the first support strip (32c) and first outer surface (42c) facing away from - or alternatively facing - the reference line of the first support strip (32c), and wherein each first attachment portion (40c) of the second support strip (32'c) forms a first half wave (58) with first piezo element (34c) facing - or alternatively facing away from - the reference line of the second support strip (32'c) and first outer surface (42c) facing away from - or alternatively facing - the reference line of the second support strip (32'c), and each second attachment portion (44c) of the second support strip (32'c) forms a second half wave (60) with second piezo element (36c) facing - or alternatively facing away from - the reference line of the second support strip (32'c) and second outer surface (46c) facing away from - or alternatively facing - the reference line of the second support strip (32'c).

15. The operating unit according to claim 13 or 14, **characterized in that** the connection element (82) is arranged in the gap between the two support strips (32c, 32'c) and is connected to the housing (12) outside the region occupied by the support strips (32c, 32'c).

16. The operating unit according to any one of claims 13 to 15, **characterized in that**, in the activated state of both support strips (32c, 32'c), the ratio of the sum of the amplitudes (76, 78) of the first and second half waves (58, 60) of the first support strip (32c) to the sum of the amplitudes (76, 78) of the first and second half waves (58, 60) of the second support strip (32c, 32'c) is inverse to the ratio of the weight of the operating element (14) to the weight of the counterbalance (30c).

17. The operating unit according to any one of claims 13 to 16, **characterized in that** the actuator (24c) is arranged along a first edge portion (26) of the operating element (14).

18. The operating unit according to any one of claims 13 to 17, **characterized in that**

    - each support strip (32c, 32'c) has at least one further dividing group (38c, 38'c), which comprises a first attachment portion (40c) and a second attachment portion (44c), which is arranged next to a first attachment portion (40c) of an adjacent dividing group (38c),
    - **in that** the connection element (82) connects the two support strips (32c, 32'c) in the first attachment portion (40c) of each further dividing group (38'c),
    - **in that** the operating element (14) is mechanically coupled to the first support strip (32c) at the second outer surface (46c) thereof in the second attachment portion (44c) of each further dividing group (38'c) and the counterbalance (30c) is mechanically coupled to the second support strip (32'c) on the second outer surface (46c) thereof in the first attachment portion (40c) of each further dividing group (38'c), and
    - **in that** a first piezo element (34c) is connected in a shear-resistant manner to the relevant support strip (32c, 32'c) at the second outer surface (46c) of each support strip (32c, 32'c) in the first attachment portion (40c) of each further dividing group (38'c), and a second piezo element (36c) is connected in a shear-resistant manner to the relevant support strip (32c, 32'c) on the first outer surface (42c) of each support strip (32c, 32'c) in the second attachment portion (44c) of each further dividing group (38'c).

19. The operating unit according to any one of claims 1 to 18, **characterized in that** the actuator (24) is formed as a piezo actuator and has an electrically excitable piezo ceramic element and a mechanical gearing mechanism for converting a linear elongation (with subsequent reduction in length) of the piezo ceramic element into a movement of the operating element (14), wherein the mechanical gearing mechanism has at least one gearing mechanism element forming the counterbalance (30) and/or part of the counterbalance (30) and/or the elastic mounting of the operating element (14) and at least one further gearing mechanism element forming the elastic mounting of the operating element (14).

**Revendications**

1. Unité de commande pour un appareil, par exemple pour un composant de véhicule, en particulier une interface homme-machine (IHM), dotée

    - d'un boîtier (12), lequel comporte un élément de commande (14) doté d'un champ de commande (16) comme par exemple un écran tactile ou une surface tactile ou un écran ou une plaque de protection d'un écran tactile ou d'un écran, et lequel est prévu pour être fixé dans/à un appareil, en particulier à un tableau de bord de véhicule ou une console centrale de véhicule,
    - dans laquelle l'élément de commande (14) est disposé élastiquement dans le boîtier (12),
    - d'un capteur (20) permettant de reconnaître une commande de l'élément de commande (14),
    - d'un actionneur (24, 24a, 24b, 24d) permettant une excitation mécanique subséquente de l'élément de commande (14) lorsqu'une commande de l'élément de commande (14) est reconnue et
    - d'un contrepoids (30, 30a), lequel est disposé de manière mobile dans/sur le boîtier (12),
    - dans laquelle le contrepoids (30, 30a) est mécaniquement excitable par le ou par l'un actionneur (24, 24a, 24b, 24d) lorsqu'une commande de l'élément de commande (14) est reconnue et
    - dans laquelle le contrepoids (30, 30a) est mobile afin de sensiblement compenser et/ou empêcher et/ou amortir des forces s'exerçant sur le boîtier (12) à la suite du mouvement de l'élément de commande (14) lors de l'activation de l'actionneur (24, 24a, 24b, 24d), **caractérisée en ce que**
    - l'actionneur (24, 24a, 24b, 24d) est prévu doté

- d'une bande de support (32, 32a) comportant un matériau élastique, en particulier de l'acier à ressort, avec une première surface extérieure (42) et une deuxième surface extérieure (44),
- dans laquelle la bande de support (32, 32a) comporte au moins un groupe diviseur (38) constitué d'une première section de montage (40), d'une deuxième section de montage (44) et d'une première section intermédiaire (48) disposée entre les deux sections de montage (40, 44), dans laquelle la première section de montage (40), la première section intermédiaire (48) et la deuxième section de montage (44) sont disposées en succession dans l'étendue longitudinale de la bande de support (32, 32a),
- dans laquelle la bande de support (32, 32a) comporte, pour plusieurs groupes diviseurs (38) adjacents dans son étendue longitudinale, une deuxième section intermédiaire (50) entre la deuxième section de montage (44) d'un groupe diviseur (38) et la première section de montage (40) du groupe diviseur (38) adjacent,
- de premiers et deuxièmes piézoéléments (34, 36) électriquement déclenchables et reliés de manière rigide à la bande de support (32, 32a), desquels chacun comporte - vu dans l'étendue longitudinale de la bande de support (32, 32a) - une longueur qui adopte une première valeur de longueur sans déclenchement électrique du piézoélément (34, 36) et une deuxième valeur de longueur différente de la première valeur de longueur lors d'un déclenchement électrique,
- dans laquelle au moins un premier piézoélément (34) est disposé dans une première section de montage (40) de la bande de support (32, 32a) sur sa première surface extérieure (42) et au moins un deuxième piézoélément (36) est disposé dans une deuxième section de montage (44) de la bande de support (32, 32a) sur sa deuxième surface extérieure (46),
- dans laquelle les premières sections intermédiaires (48) et, pour autant qu'elles soient présentes, les deuxièmes sections intermédiaires (50) de la bande de support (32, 32a) sont accouplées mécaniquement à des fins de fixation de la bande de support (32, 32a) au boîtier (12) et
- dans laquelle la bande de support (32, 32a) est accouplée mécaniquement à l'élément de commande (14) dans une première section de montage (40) et est accouplée mécaniquement au contrepoids (30) dans une deuxième section de montage (44) et
- **en ce qu'**une unité de déclenchement (74) est prévue, au moyen de laquelle les piézoéléments (34, 36) sont déclenchables pour le transfert de la bande de support (32, 32a) depuis l'état de repos de celle-ci, où l'élément de commande (14) et le contrepoids (30) disposés des deux côtés de la bande de support (32, 32a) présentent un premier écart l'un par rapport à l'autre, dans un état d'activation ondulé par déplacement de l'élément de commande (14) et du contrepoids (30) dans des directions opposées et pour le transfert retour de la bande de support (32, 32a) depuis l'état d'activation vers l'état de repos.

2. Unité de commande selon la revendication 1, **caractérisée en ce que** la bande de support (32, 32a) s'étend dans son état de repos le long d'une ligne de référence et **en ce que** la forme ondulée (56) de la bande de support (32, 32a) dans son état d'activation présente des premières alternances (58) d'un côté de la ligne de référence et des deuxièmes alternances (60) du côté opposé de la ligne de référence, dans laquelle chaque première section de montage (40) de la bande de support (32, 32a) forme une première alternance (58) avec le premier piézoélément (34) tourné vers - ou alternativement se détournant de - la ligne de référence ainsi qu'avec la deuxième surface extérieure (46) se détournant de - ou alternativement tournée vers - la ligne de référence et chaque deuxième section de montage (44) de la bande de support (32, 32a) forme une deuxième alternance (60) avec le deuxième piézoélément (36) tourné vers - ou alternativement se détournant de - la ligne de référence ainsi qu'avec la deuxième surface extérieure (46) tournée vers - ou alternativement se détournant de - la ligne de référence.

3. Unité de commande selon la revendication 1 ou 2, **caractérisée en ce que** la bande de support (32, 32a) est prévue à ses extrémités (70, 72, 72a) opposées dans l'étendue longitudinale avec respectivement une deuxième section intermédiaire (50), à côté de laquelle est disposée une première section de montage (40), laquelle pour sa part est espacée par rapport à une deuxième section de montage (44) adjacente par une première ou une deuxième section intermédiaire (48, 50).

4. Unité de commande selon l'une des revendications 1 à 3, **caractérisée en ce que** la bande de support (32, 32a) est prévue sur ses bords latéraux avec respectivement une première collerette de montage (62) pour la fixation sur le boîtier (12), **en ce que** les collerettes de montage (62) sont reliées par des traverses (70) aux premières et, pour autant qu'elles soient présentes, les deuxièmes sections intermédiaires (48, 50), et **en ce que** sont réalisés des évidements (66, 68) disposés dans la bande de support (32, 32a) et/ou dans les collerettes de montage (62) entre les traverses (70) et contiguës aux bords latéraux de la bande de support (32, 32a).

**5.** Unité de commande selon la revendication 4, **caractérisée en ce que** les premières collerettes de montage (62) s'étendent de manière coudée par rapport au côté de la bande de support (32, 32a), en particulier s'étendent de manière coudée à angle droit par rapport à son côté.

**6.** Unité de commande selon l'une des revendications 1 à 5, **caractérisée en ce que** la bande de support (32, 32a) est prévue à ses extrémités (72) opposées dans l'étendue longitudinale avec respectivement une deuxième collerette de montage (64, 64a) pour la fixation au boîtier (12).

**7.** Unité de commande selon la revendication 6, **caractérisée en ce que** les deuxièmes collerettes de montage (64, 64a) s'étendent de manière coudée par rapport au côté de la bande de support (32, 32a), en particulier s'étendent de manière coudée à angle droit par rapport à son côté.

**8.** Unité de commande selon l'une des revendications 1 à 3, **caractérisée en ce que** des éléments de liaison (62a) dépassent de la bande de support (32, 32a) à l'intérieur des premières et, pour autant qu'elles soient présentes, des deuxièmes sections intermédiaires (48, 50) pour la fixation de la bande de support (32, 32a) dans/sur le boîtier (12).

**9.** Unité de commande selon la revendication 8, **caractérisée en ce que** le contrepoids (30a) est réalisé comme un corps de bande de matière comportant des évidements (80) à travers lesquels s'étendent les éléments de liaison (62) avec du jeu.

**10.** Unité de commande selon l'une des revendications 1 à 9, **caractérisée en ce que** dans l'état d'activation de la bande de support (32, 32a) la proportion de l'amplitude (76) de la première alternance (58) à l'amplitude (78) de la deuxième alternance (60) est l'inverse de la proportion du poids de l'élément de commande (14) au poids du contrepoids (30, 30a).

**11.** Unité de commande selon l'une des revendications 1 à 10, **caractérisée en ce que** le contrepoids (30, 30a) est réalisé comme une bande de matière.

**12.** Unité de commande selon l'une des revendications 1 à 11, **caractérisée en ce que** l'actionneur (24, 24a, 24b, 24d) est disposé le long d'une première section de bord (26) de l'unité de commande (14).

**13.** Unité de commande pour un appareil, par exemple pour un composant de véhicule, en particulier une interface homme-machine (IHM), dotée

- d'un boîtier (12), lequel comporte un élément de commande (14) doté d'un champ de commande (16) comme par exemple un écran tactile ou une surface tactile ou un écran ou une plaque de protection d'un écran tactile ou d'un écran, et lequel est prévu pour être fixé dans/à un appareil, en particulier à un tableau de bord de véhicule ou une console centrale de véhicule,
- dans laquelle l'élément de commande (14) est disposé élastiquement dans le boîtier (12),
- d'un capteur (20) permettant de reconnaître une commande de l'élément de commande (14),
- d'un actionneur (24c) permettant une excitation mécanique subséquente de l'élément de commande (14) lorsqu'une commande de l'élément de commande (14) est reconnue et
- d'un contrepoids (30), lequel est disposé de manière mobile dans/sur le boîtier (12),
- dans laquelle le contrepoids (30) est mécaniquement excitable par le ou par un actionneur (24c) lorsqu'une commande de l'élément de commande (14) est reconnue et
- dans laquelle le contrepoids (30) est mobile afin de sensiblement compenser et/ou empêcher et/ou amortir des forces s'exerçant sur le boîtier (12) à la suite du mouvement de l'élément de commande (14) lors de l'activation de l'actionneur (24c),
**caractérisée en ce que**
- l'actionneur (24c) est prévu doté

  - d'une première bande de support (32c) comportant un matériau élastique, en particulier de l'acier à ressort, avec une première surface extérieure (42c) et une deuxième surface extérieure (46c),
  - dans laquelle la première bande de support (32c comporte au moins un groupe diviseur (38c) avec deux premières sections de montage (40c) et respectivement une deuxième section de montage (44c) disposée entre celles-ci, dans laquelle les sections de montage (40c, 44c) sont disposées en succession dans l'étendue longitudinale de la première bande de support (32c),
  - d'une deuxième bande de support (32'c) parallèle à la première bande de support (32c) comportant un matériau élastique, en particulier de l'acier à ressort, avec une première surface extérieure (32c) tournée vers la première surface extérieure (42c) de la première bande de support (32c) et une deuxième surface extérieure (46c) se détournant de la première surface extérieure (42c) de la première bande de support (32c),
  - dans laquelle la deuxième bande de support (32'c) comporte au moins un groupe diviseur (38c) avec deux premières sections de montage (40c) et respectivement une deuxième section de montage (44c) disposée entre celles-ci, dans laquelle les sections de montage (40c, 44c) sont disposées en succession dans l'étendue longitudinale de la deuxième bande de support (32'c),

- d'un élément de liaison (82), au moyen duquel les deux bandes de support (32c, 32'c) sont reliées l'une à l'autre et qui est relié au boîtier (12) pour la fixation des deux bandes de support (32c, 32'c), dans laquelle l'élément de liaison (82) relie les premières sections de montage (40c) de la première bande de support (32c) sur la première surface extérieure (32c) de celle-ci et les premières sections de montage (40c) de la deuxième bande de support (32'c) sur la première surface extérieure (42c) de celle-ci,

- de premiers et deuxièmes piézoéléments (34c, 36c) électriquement déclenchables et reliés de manière rigide en poussée aux deux bandes de support (32c, 32'c), desquels chacun comporte - vu dans l'étendue longitudinale de la bande de support (32c, 32'c) - une longueur qui adopte une première valeur de longueur sans déclenchement électrique du piézoélément (34c, 36c) et une deuxième valeur de longueur différente de la première valeur de longueur lors d'un déclenchement électrique, dans laquelle, dans chaque première section de montage (40c) de la première bande de support (32c), au moins un premier piézoélément (34c) est disposé sur la deuxième surface extérieure (46c) de celle-ci, ainsi que, dans chaque deuxième section de montage (44c) de la première bande de support (32c), au moins un deuxième piézoélément (36c) est disposé sur la première surface extérieure (42c) de celle-ci et dans laquelle, dans chaque première section de montage (40c) de la deuxième bande de support (32'c), au moins un premier piézoélément (34c) est disposé sur la deuxième surface extérieure (46c) de celle-ci, ainsi que, dans chaque deuxième section de montage (44c) de la deuxième bande de support (32'c), au moins un deuxième piézoélément (36c) est disposé sur la première surface extérieure (42c) de celle-ci et

- dans laquelle la première bande de support (32c) est accouplée mécaniquement à l'élément de commande (14) dans chaque deuxième section de montage (44c) et la deuxième bande de support (32'c) est accouplée mécaniquement au contrepoids (30c) dans chaque deuxième section de montage (44c), et

- **en ce qu'**une unité de déclenchement (74) est prévue, au moyen de laquelle les piézoéléments (34c, 36c) sont déclenchables pour le transfert des deux bandes de support (32c, 32'c) depuis leur état de repos respectif, où l'élément de commande (14) et le contrepoids (30) se trouvant des deux côtés de l'arrangement constitué par les deux bandes de support (32c, 32'c) et l'élément de liaison (82) présentent un premier écart l'un par rapport à l'autre, dans un état d'activation ondulé par déplacement de l'élément de commande (14) et du contrepoids (30) dans des directions opposées, où l'élément de commande (14) et du contrepoids (30) présentent un deuxième écart l'un par rapport à l'autre différent du premier écart, et pour le transfert retour des bandes de support (32c, 32'c) depuis leur état d'activation respectif vers leur état de repos respectif.

**14.** Unité de commande selon la revendication 13, **caractérisée en ce que** les deux bandes de support (32c, 32'c) s'étendent le long d'une ligne de référence dans leur état de repos respectif et **en ce que** les formes ondulées (56) des deux bandes de support (32c, 32'c) dans leur état d'activation respectif présentent des premières alternances (58) d'un côté de la ligne de référence respective et des deuxièmes alternances (60) du côté opposé de la ligne de référence respective, dans laquelle chaque première section de montage (40c) de la première bande de support (32c) forme une première alternance (58) avec le premier piézoélément (34c) tourné vers - ou alternativement se détournant de - la ligne de référence de la première bande de support (32c) et la première surface extérieure (42c) se détournant de - ou alternativement tournée vers - la ligne de référence de la première bande de support (32c) de même que chaque deuxième section de montage (44c) de la première bande de support (32c) forme une deuxième alternance (60) avec le deuxième piézoélément (36c) tourné vers - ou alternativement se détournant de - la ligne de référence de la première bande de support (32c) et la première surface extérieure (42c) se détournant de - ou alternativement tournée vers - la ligne de référence de la première bande de support (32c) et dans laquelle chaque première section de montage (40c) de la deuxième bande de support (32'c) forme une première alternance (58) avec le premier piézoélément (34c) tourné vers - ou alternativement se détournant de - la ligne de référence de la deuxième bande de support (32'c) et la première surface extérieure (42c) se détournant de - ou alternativement tournée vers - la ligne de référence de la deuxième bande de support (32'c) de même que chaque deuxième section de montage (44c) de la deuxième bande de support (32'c) forme une deuxième alternance (60) avec le deuxième piézoélément (36c) tourné vers - ou alternativement se détournant de - la ligne de référence de la deuxième bande de support (32'c) et la deuxième surface extérieure (46c) se détournant de - ou alternativement tournée vers - la ligne de référence de la deuxième bande de support (32'c).

15. Unité de commande selon la revendication 13 ou 14, **caractérisée en ce que** l'élément de liaison (82) est disposé dans l'espace intermédiaire entre les deux bandes de support (32c, 32'c) et est relié au boîtier (12) à l'extérieur de la zone occupée par les bandes de support (32c, 32'c).

16. Unité de commande selon l'une des revendications 13 à 15, **caractérisée en ce que** dans l'état d'activation des deux bandes de support (32c, 32'c) la proportion de la somme des amplitudes (76, 78) des premières et deuxièmes alternances (58, 60) de la première bande de support (32c) à la somme des amplitudes (76, 78) des premières et deuxièmes alternances (58, 60) de la deuxième bande de support (32'c) est l'inverse de la proportion du poids de l'élément de commande (14) au poids du contrepoids (30c).

17. Unité de commande selon l'une des revendications 13 à 16, **caractérisée en ce que** l'actionneur (24c) est disposé le long d'une première section de bord (26) de l'unité de commande (14).

18. Unité de commande selon l'une des revendications 13 à 17, **caractérisée**

> - **en ce que** chaque bande de support (32c, 32'c) comporte au moins un groupe diviseur supplémentaire (38c, 38'c), lequel comporte une première section de montage (40c) et une deuxième section de montage (44c), laquelle est disposée à côté d'une première section de montage (40c) d'un groupe diviseur adjacent (38c),
> - **en ce que** l'élément de liaison (82) relie les deux bandes de support (32c, 32'c) dans la première section de montage (40c) de chaque groupe diviseur supplémentaire (38'c),
> - **en ce que** l'élément de commande (14) est accouplé mécaniquement à la première bande de support (32c) sur sa deuxième surface extérieure (46c) dans la deuxième section de montage (44c) de chaque groupe diviseur supplémentaire (38'c) et le contrepoids (30c) est accouplé mécaniquement à la deuxième bande de support (32'c) sur sa deuxième surface extérieure (46c) dans la première section de montage (40c) de chaque groupe diviseur supplémentaire (38'c), et
> - **en ce que** sur la deuxième surface extérieure (46c) de chaque bande de support (32c, 32'c) dans la première section de montage (40c) de chaque groupe diviseur supplémentaire (38'c) un premier piézoélément (34c) est relié de manière rigide à la bande de support (32c, 32'c) concernée et sur la première surface extérieure (42c) de chaque bande de support (32c, 32'c) dans la deuxième section de montage (44c) de chaque groupe diviseur supplémentaire (38'c) un deuxième piézoélément (36c) est relié de manière rigide à la bande de support (32c, 32'c) concernée.

19. Unité de commande selon l'une des revendications 1 à 18, **caractérisée en ce que** l'actionneur (24) est réalisé comme un piézo-actionneur et comporte un élément en piézocéramique électriquement excitable ainsi qu'une transmission mécanique destinée à convertir une dilatation linéaire avec une contraction linéaire subséquente de l'élément en piézocéramique en un mouvement de l'élément de commande (14), dans laquelle la transmission mécanique comporte au moins un élément de transmission formant le contrepoids (30) et/ou une partie du contrepoids (30) et/ou le support élastique de l'élément de commande (14) et comporte au moins un élément de transmission supplémentaire formant le support élastique de l'élément de commande (14).

**Fig.1**
(Stand der Technik)

Fig.2

Fig.3

**Fig.4**

**Fig.5**

**Fig.6**

VII

VII

**Fig.7**

IX

IX

Fig.8

Fig.9

**Fig.10**

EP 3 576 974 B1

**Fig.11**

Fig.12

**Fig.13**

EP 3 576 974 B1

**Fig.14**

EP 3 576 974 B1

Fig.15

**Fig.16**

EP 3 576 974 B1

Fig.17

EP 3 576 974 B1

**Fig.18**

Fig.19

EP 3 576 974 B1

**Fig.20**

EP 3 576 974 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2011276878 A